# EUROPEAN PATENT SPECIFICATION

(11) **EP 2 284 005 B1**
(45) Date of publication and mention of the grant of the patent: **02.05.2012**
(21) Application number: 09167558.7
(22) Date of filing: 10.08.2009
(51) Int. Cl.: B41C 1/10, G03F 7/004

(54) **Lithographic printing plate precursors with beta-hydroxy alkylamide crosslinkers**
Lithografische Druckplattenvorläufer mit Betahydroxy-Alkylamid-Vernetzern
Précurseurs de plaque d'impression lithographique dotés d'agents de réticulation à base de bêta-hydroxyalkylamide

(43) Date of publication of application: 16.02.2011
(73) Proprietor: Eastman Kodak Company, Rochester, NY 14650-2201 (US)
(72) Inventor: Savariar-Hauck, Celin, 37534 Badenhausen (DE); Hauck, Gerhard, 37534 Badenhausen (DE)
(74) Representative: Weber, Etienne Nicolas

(56) References cited:
- EP-A- 1 203 763
- WO-A-03/058345
- US-B1- 6 525 152

## Description

The present invention relates to lithographic printing plate precursors comprising a β-hydroxy alkylamide crosslinker in the coating. It also relates to a method for preparing an imaged printing plate from the precursor as well as a lithographic printing plate obtainable by this method.

The technical field of lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, however, the printing ink is first transferred to an intermediate material, referred to as blanket, which then in turn transfers the printing ink onto the surface of the material on which the image is to be formed; this technique is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic. The differentiation between image and non-image areas takes place during exposure, for which a film is attached to the printing plate precursor under vacuum in order to guarantee good contact. The plate is then exposed by means of a radiation source part of which is comprised of UV radiation. When a positive plate is used, the area on the film corresponding to the image on the plate is so opaque that the light does not reach the plate, while the area on the film corresponding to the non-image area is clear and allows light to permeate the coating, whose solubility increases. In the case of a negative plate, the opposite takes place: The area on the film corresponding to the image on the plate is clear, while the non-image area is opaque. The coating beneath the clear film area is hardened due to the incident light, while the area not affected by the light is removed during developing. The light-hardened surface of a negative working plate is therefore oleophilic and accepts printing ink, while the non-image area that used to be coated with the coating removed by the developer is desensitized and therefore hydrophilic.

Alternatively, the plate can also be image-wise exposed digitally without a film. Since the late 1990s plate precursors with heat-sensitive layers are developed wherein by image-wise direct heating or irradiation with IR radiation that is converted into heat, differences in the developer solubility of the heated and unheated areas of the coating are generated; such plates are often referred to as "IR plates" or "thermo plates". According to recent developments plate precursors have been developed which can be imaged by imagewise exposing them to near UV radiation or VIS radiation emitted by a UV laser (including 2-photon excitation systems).

For a clean printed image it is necessary - independent from the type of precursor used - that the image areas (i.e. the image-wise remaining coating) accept the printing ink well, while the non-image areas (i.e. the image-wise revealed substrate, such as e.g. an aluminum substrate) should not accept the printing ink. In order to protect the image-wise revealed substrate, such as e.g. an aluminum substrate, against fingerprints, the formation of aluminum oxide, corrosion and mechanical attacks, such as scratches, when the printing plate is mounted on the press or stored for a certain time, i.e. to maintain and possible improve the hydrophilic nature of the non-image areas, the developed printing plate is usually subjected to a "gumming" treatment (also referred to as "desensitizing" or "finishing"). Gumming the plate prior to storing it or before long periods of standstill of the printing machine ensures that the non-image areas remain hydrophilic. When printing is started, the gumming solution has to be able to be washed off the plate quickly with the fountain solution so that the image areas are capable of accepting ink immediately. Gumming solutions have been known for a long time. The first gumming solutions were based on gum arabic and also nowadays gum arabic is widely used. Years ago attempts were made to find polymeric gum substitutes as there are only limited resources of gum arabic. Since polymer solutions with some types of plates may cause blinding problems attempts were made to remove the polymers from the desensitizing compositions resulting in solutions of particular salts like phosphate salts and optionally surfactants. In other attempts sugars and dextrin type materials often replaced the phosphate salts.

Gumming compositions are for instance described in DE 29 26 645 A1, DE 20 42 217 A1, US 4,880,555 A1, US 4,033,919 A. A finisher in the form of an emulsion is described in US 4,162,920 A1. Further finishers are described in EP 0 397 407 A2 and EP 0 024 298A2.

WO 03/058345 A2 describes a negative bottom photoimageable antireflective coating which is coated below a negative photoresist.

In order to improve the print run length and solvent resistance imaged lithographic printing plates are often subjected to a post-baking at a temperature of about 200 to 250°C. Such a high temperature, however, results in the disadvantage that the aluminum substrate tends to get distorted which in turn causes problems on the press. Also, there are coating formulations that cannot be baked because they lack the functional groups required for crosslinking. One possibility of overcoming such problems is the selection of specific polymers and or monomers which, however, are not readily available and their synthesis results in extra costs.

It is therefore the object of the present invention to provide a lithographic printing plate precursor which is bakeable after imaging at relatively low temperature, does not require expensive additional components for the coating, does not suffer from ageing problems and at the same time does not suffer from deterioration of resolution and clear point.

This object is surprisingly achieved by a lithographic printing plate precursor comprising
a substrate, and
a positive working imageable coating which comprises
(i) a polymer containing acidic groups selected from -COOH, -SO₃H, -SO₂NHR, -PO₃H₂,-PO₂H₂ and 1H-tetrazol groups and
(ii) at least one β-hydroxy alkylamide crosslinker.

The term "printing plate precursor" as used in the present invention relates to an unimaged plate (i.e. that has not been image-wise exposed and developed) from which a printing plate is produced by image-wise exposure and developing. The term "printing plate" (also referred to as "printing form") as used in the present invention refers to an already imaged plate produced from a printing plate precursor.

Within the present invention "gumming composition", "finisher composition" and "desensitzer composition" are used interchangeable.

Within the present invention the expression "a coating" or "one coating" does not specify the structure of the coating; it encompasses single layer coatings as well as multi-layer coatings e.g. two-layer coatings.

Within the present invention the use of the articles "a", "an" and "the" is not necessarily meant to refer to only a single compound.

The term "developing" as used in the present invention relates to the removal of the non-image areas of the radiation sensitive precursor coating after exposure to radiation by an aqueous alkaline developer solution.

"One-step-processing", "single-step processing" or "2 in 1 processing" refers to a process where developing and gumming are carried out in a single step by using a suitable liquid composition.

Within the present invention the term "polymer" also includes copolymers unless defined otherwise.

Any embodiment, preferred range etc. described below can be combined with one or more other embodiments, preferred ranges etc. described below. All such possible combinations are considered to be within the scope of the present disclosure, even if they are not explicitly mentioned.

### PRECURSORS

The printing plate precursors are positive working precursor; according to one embodiment the precursors are sensitive to UV/VIS radiation (i.e. radiation of a wavelength of about 250 to 750 nm), according to another embodiment the precursors are sensitive to IR radiation (i.e. radiation of a wavelength of about >750 nm to 1300 nm) or direct heat application.

Any type of precursor, especially the examples of suitable precursors described in the following, can be combined with any other feature described below.

According to one embodiment of the present invention the precursor is sensitive to IR radiation and its coating is a multilayer coating (preferably a 2-layer coating).

More details of suitable precursors are described in the following:

### Substrates

The substrate used for the precursors is preferably a dimensionally stable plate or foil-shaped material like one that has already been used as a substrate for printing matter. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred since it shows a remarkable degree of dimensional stability, is inexpensive and furthermore exhibits excellent adhesion to the radiation-sensitive coating. Furthermore, a composite film can be used wherein an aluminum foil has been laminated onto a plastic film, such as e.g. a polyethylene terephthalate film, or paper, or a plastic film onto which aluminum has been applied by means of vapor deposition. Preferred substrates are metal substrates, wherein the term "metal substrate" as used herein also encompasses composite films with the upper-most layer being a metal layer or foil.

A metal substrate, in particular an aluminum substrate, is preferably subjected to a surface treatment, for example graining by brushing in a dry state or brushing with abrasive suspensions, or electrochemical graining, e.g. by means of a hydrochloric acid electrolyte or HNO₃, and optionally anodizing, e.g. in sulfuric acid or phosphoric acid. According to a preferred embodiment the metal substrate comprises an Al₂O₃-, ZnO-, SiO₂- or TiO₂-layer wherein layer in this connection does not necessarily mean a totally continuous layer over the whole surface of the substrate.

An aluminum foil which preferably has a thickness of 0.1 to 0.7 mm, more preferred 0.15 to 0.5 mm, is an especially preferred substrate. It is preferred that the foil be grained (preferably electrochemically) and then show an average roughness of 0.2 to 1 µm, especially preferred 0.3 to 0.8 µm.

Ths substrate can also be a cylindrical surface having the imageable coating thereon, and thus be an integral part of a printing press. The use of such imaging cylinders is described for example in US 5,713,287.

According to an especially preferred embodiment, the grained aluminum foil was furthermore anodized. The layer weight of the resulting aluminum oxide is preferably 1.5 to 5 g/m², especially preferred 2 to 4 g/m².

A metal substrate can additionally be subjected to a posttreatment (so called "sealing") with an aqueous solution of e.g. alkali metal silicate, calcium zirconium fluoride, hexafluorosilicic acid, phosphate/fluoride, polyvinylphosphonic acid, vinylphosphonic acid copolymers, or phosphonic acid thereby providing a hydrophilizing layer (also referred to as "interlayer") on its surface; the substrate may also be treated with a phosphate solution that may further contain an inorganic fluoride.

The backside (non-imaging side) of the substrate may be coated with antistatic agents and/or slipping layers or a matte layer to improve handling and "feel" of the imageable element.

The details of the above-mentioned substrate treatments are well known to the person skilled in the art.

### Imageable Coating

The imageable coating of a precursor according to the present invention can be a single layer coating or a multilayer coating and is preferably a 2-layer coating.

The essential components of the coating with respect to the bakeability of the plate are
(a) a polymer containing acidic groups selected from -COOH, -SO₃H, -SO₂NHR, -PO₃H₂, -PO₂H₂ and 1H-tetrazol groups (preferably -COOH and/or 1H tetrazol groups) and
(b) a β-hydroxy alkylamide crosslinker.

It is possible to add these compounds as additional components to known coatings. If the coating comprises two or more layers they can be added to the formulation of at least one layer. If there are 2 layers they can both be added to the formulation of the bottom layer, or both are added to the top layer, or both are added to each layer so that each layer comprises the acidic polymer (a) and crosslinker (b) defined above; it is preferred that polymer (a) and crosslinker (b) are added only to the bottom layer.

If the known coating/layer composition already comprises a polymeric binder with acidic groups selected from COOH, SO₃H, -SO₂NHR, PO₃H₂, PO₂H₂ and 1H-tetrazol groups no additional polymer needs to be added but adding at least one β-hydroxy alkylamide crosslinker is sufficient for achieving the object of the present invention.

One kind of suitable polymers with acidic groups is described in US,6,525,152 B1; these copolymers consist of at least one unit A, at least one unit B and at least one unit C: 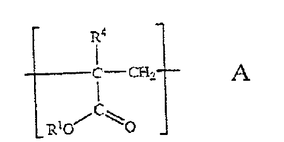 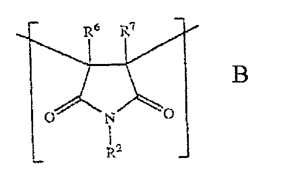 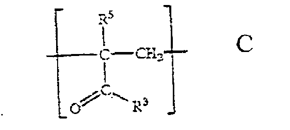 wherein R¹ is hydrogen, an arylsufonamide group (like phenylsulfonamide) or (C₁-C₁₂) alkyl having at least one carboxy group,
R⁴ and R⁵ are independently hydrogen, halogen or (C₁-C₁₂) alkyl,
R² is hydrogen, aryl, optionally having one or several substituents selected from halogen, alkyl, -NO₂ and -OH, alkyl, cylcoalkyl, an arylsulfonamide group (like phenylsulfonamide) or a sulphonamide group,
R⁶ and R⁷ are independently hydrogen, halogen or (C₁-C₄) alkyl or phenyl,
R³ is hydrogen, (C₁-C₁₂) alkyl having at least one hydroxy group and optionally also one or several substituents selected from halogen and -NO₂, (C₃-C₈) cycloalkyl having at least one hydroxy group and optionally also one or several substituents selected from halogen and -NO₂, aryl having at least one hydroxy group and optionally one or several substituents selected from halogen, (C₁-C₁₂) alkyl and NO₂, a (C₁-C₁₂) alkylsulfonamide group, an aryl sulfonamide group, -NH(CH₂)ₙO-alkyl (n being an integer from 1 to 20), -NHR⁸ (R⁸ being hydrogen, C₁-C₁₂ alkyl or aryl), or C₁-C₁₂ alkoxy.

The weight-average molecular weight of those copolymers is preferably 500 to 1,000,000, especially preferred 2000 to 250,000. The preparation of these copolymers is inexpensive and can be carried out according to usual polymerization methods.

Particularly suitable polymers thereof are copolymers of (meth)acrylic acid, N-phenylmaleimide and (meth)acryl amide as described in DE 199 36 331 and US 6,525,152 B1; the (meth)acrylic acid unit is preferably present in an amount of 5 to 50 mol%, the N-phenylmaleimide in an amount of 20 to 70 mol% and the (meth)acrylamide in an amount of 10 to 50 mol% based on the copolymer.

Polymers with pendant 1H-tetrazole groups preferably have a weight-average molecular weight of at least 500 and up to 500,000, more typically, from 5,000 to 100,000.

Such polymers useful in this invention can be generally represented by the following structure:

-(A)ₓ-(B)_{y}-

wherein A represents recurring units comprising the 1H-tetrazole groups 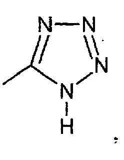 B represents recurring units not containing 1H-tetrazole groups, x is from about 3 to 100 mol %, and y is from 0 to about 97 mol %. Typically, x is from about 3 to about 90 mol %, y is from about 10 to about 97 mol %, and B represents recurring units derived, for example, from one or more allyl (meth)acrylates, alkyl (meth)acrylates, hydroxyalkyl (meth)acrylates, (meth)acrylamides that can be substituted by alkyl or aryl groups, (meth)acrylates of polyethylene oxide or propylene oxide, (meth)acrylonitriles, styrene or styrene derivatives, vinyl acetate, vinyl carbazole, vinyl pyrrolidone, vinyl alcohol, N-substituted maleimides, or half esters of ring-opened maleic acid anhydrides. Other monomers from which B recurring units can be derived would be readily apparent to a skilled artisan.

A can represent recurring units providing a carbon-carbon backbone derived from one or more ethylenically unsaturated polymerizable monomers, and the 1H-tetrazole groups can be attached to the backbone through a linking group L comprising a -C(=O)-NR¹-, -NR-, -NR¹-(C=O)-NR²-, -S-, -OCO(=O)-, or -CH=N- group, or a combination thereof. Particularly useful linking groups include -C(=O)-NR¹- and -NR¹-(C=O)-NR²-. The noted linking groups can be directly attached to the backbone or attached through an organic group having up to 30 atoms in the linking chain.

The 1H-tetrazole groups can be introduced into polymers in a number of ways. For example, the polymers useful in the present invention can be made by co-polymerization

Alternatively, the 1H-tetrazole groups can be introduced into polymers already having reactive functionalities for the amino group in 1H-tetrazole-5-amine.

These suitable polymers with 1H-tetrazole groups are also described in US 2009/0142695.

Of course, other polymers with 1H-tetrazole groups can also be used.

Suitable polymers with sulfonaminde groups -SO₂-NHR (with R being selected from hydrogen and C₁-C₁₂ alkyl) are described in various patent applications, for instance in US 7,241,556 B1, EP 0 901 902 A2, EP 0 909 657 A2, EP 1 826 021 A1, EP 1 604 818 A1, EP 1 038 668 A2, WO 99/63407 and US 6,525,152 B1.

In addition to the essential polymer with acidic groups further polymers can be present as binders like novolac resins and resol resins.

The amount of the polymer with acidic groups is preferably 10 to 90 wt% based on the dry coating weight of the total coating if the total coating has a single layer structure and based on the dry coating weight of that layer where the polymer is present if the coating has a multi-layer structure, more preferably 30 to 85 wt%.

The other essential component is the β-hydroxy alkylamide crosslinker. It is clear that the β-hydroxy alkylamide crosslinker has to comprise at least 2 β-hydroxy alkylamide groups in order to be suitable as crosslinker. The crosslinker is preferably represented by the following formula 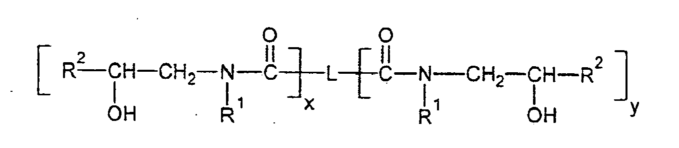 wherein each R¹ is independently selected from H, C₁-C₅alkyl and 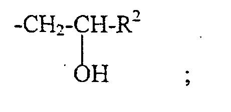 each R² is independently selected from H and C₁-C₅ alkyl,
L is a monovalent or polyvalent organic radical selected from saturated, unsaturated and aromatic hydrocarbons containing 1 to 20 carbon atoms and optionally further substituents,
x is 1 or 2,
y is 0, 1 or 2,
with x+y being at least 2 if R¹ is different from

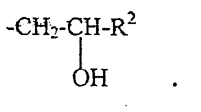

Each R¹ is preferably independently selected from H and 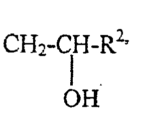 more preferably

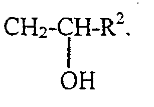

Each R² is preferably independently selected from H and C₁-C₂ alkyl, more preferably H.

L is preferably an optionally substituted aryl like an optionally substituted phenyl ring ,or an alkylene group -(CH₂)ₜ- with t being an integer from 2 to 12, preferably 3 to 10, more preferably from 3 to 6.

According to the present invention one kind of β-hydroxyalkylamide crosslinker or a mixture of 2 or more different kinds can be used.

Suitable β-hydroxyalkylamide crosslinkers and methods for their production are described, e.g. in EP 1 203 763 A2, EP 0 322 834 A2 and US 4,801,680. Also such crosslinkers are commercially available, e.g. as Vestagon® HA320 (Evonik Industries).

The essential components of the coating described above are present in positive working coatings; the coatings can be UV sensitive or IR/heat sensitive. The essential components can be added to all known coating chemistries for instance to those described in detail below

### Negative working radiation-sensitive elements (not within the claims)

Negative working coatings are described in numerous references, e.g. UV-sensitive coatings on the basis of negative diazo resins are described in EP 0 752 430 B1, photopolymer layers sensitive to 405 nm are described in DE 103 07 451, photopolymer layers sensitive to VIS are described in EP 0 684 522 B1 and IR-sensitive polymerizable systems are described in DE 199 06 823 A1. Negative working coatings with a "physical" instead of a "chemical" mechanism are for instance described in EP 0 770 497 A1, EP 0 514 145 A1 and EP 1 342 568 A1; the plates described in these documents are imaged by coalescence of polymer particles.

### PHOTOPOLYMERIZATION (UV/VIS AND IR)

One type of negative working coating applied onto a substrate comprises (a) at least one absorber component selected from photoinitiators and sensitizer/coinitiator systems which absorbs radiation of a wavelength in the range of 250 to 1,200 nm and is capable of initiating a free-radical polymerization, (b) at least one free-radical polymerizable monomer, oligomer and/or prepolymer, and optionally (c) at least one polymeric binder.

### Absorber component

The radiation-sensitive coating furthermore comprises at least one absorber component selected from photoinitiators and sensitizer/coinitiator systems.

The absorber component is selected such that it is capable of significant absorption in the range in which the radiation source to be used later on during imaging emits; preferably, the absorber shows an absorption maximum in that range. Thus, if the radiation-sensitive element is e.g. going to be imaged by means of an IR laser, the absorber should essentially absorb radiation in the range of about 750 to 1,200 nm and preferably show an absorption maximum in that range. On the other hand, if imaging is to be carried out by means of UV/VIS radiation, the absorber should essentially absorb radiation in the range of about 250 to 750 nm and preferably show an absorption maximum in that range. Suitable photoinitiators and/or sensitizers are known to the person skilled in the art, or it can easily be determined whether significant absorption occurs in the desired wave length range by means of simple tests (e.g. recording an absorption spectrum).

Within this invention, a photoinitiator is a compound capable of absorbing radiation when exposed and of forming free radicals by itself, i.e. without the addition of coinitiators. Examples of suitable photoinitiators absorbing UV or VIS radiation include for instance triazine derivatives with I to 3 CX₃ groups (wherein every X is independently selected from a chlorine or bromine atom, and is preferably a chlorine atom) and hexaarylbisimidazole compounds.

A sensitizer as referred to in the present invention is a compound which can absorb radiation when it is exposed but which *cannot* by itself, i.e. without the addition of coinitiators, form free radicals.

All light-absorbing compounds that are photooxidizable or photoreducible or capable of transferring their excitation energy to receptor molecules are suitable sensitizers for use in the present invention.

Sensitizers suitable for the UV range of the electromagnetic spectrum are for instance coumarins as disclosed in WO 2004/049068 A1, bisoxazole derivatives and analogues as disclosed in WO 2004/074929 A2, oxazole compounds as described in detail in WO 2004/074930 A2, 1,4-dihydropyridine compounds as described in WO 2004/111731 A1, as well as the sensitizers disclosed in WO 2006/053689, DE 10 2004 022 137 B3, and WO 2007/090550.

If the radiation-sensitive elements are to be exposed with VIS laser diodes, the cyanopyridone derivatives described in WO 03/06941 A1 are for example suitable as sensitizers.

If the radiation-sensitive elements are to be exposed with IR radiation any suitable IR absorber (for instance those described below for single layer negative working IR-sensitive elements) can be used.

The sensitizers are used in combination with one or more coinitiators. Additionally, photoinitiators can be used; however, this is not preferred.

A coinitiator as referred to in the present invention is a compound that is essentially unable to absorb when irradiated but forms free radicals together with the radiation-absorbing sensitizers used in the present invention. The coinitiators are for example selected from onium compounds like diaryliodonium borats; N-arylglycines and derivatives thereof; aromatic sulfonyl halides; trihalomethylarylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit; hexaarylbiimidazoles; thiol compounds; 1,3,5-triazine derivatives with 1 to 3 CX₃ groups (wherein every X is independently selected from a chlorine or bromine atom, and is preferably a chlorine atom); oxime ethers and oxime esters; metallocenes; acylphosphine oxides, diacylphosphine oxides and peroxides, α-hydroxy or α-amino acetophenones, acylphosphines, acylphosphinesulfides, carbonyl compounds such as aromatic ketones or quinones, Michler's ketone, thioxanthone derivatives, anthraquinone derivatives and fluorenone derivatives.

Further examples of suitable sensitizers and coinitiators for IR-sensitive coatings are also mentioned in WO 2004/041544, WO 2000/48836 and DE 10 2004 003143.

### Free-radical polymerizable component

All monomers, oligomers and polymers which comprise at least one C-C double bond can be used as free-radical polymerizable monomers, oligomers and polymers. Monomers/oligomers/polymers with C-C triple bonds can also be used, but they are not preferred. Suitable compounds are well known to the person skilled in the art and can be used in the present invention without any particular limitations. Esters of acrylic and methacrylic acids, itaconic acid, crotonic and isocrotonic acid, maleic acid and fumaric acid with one or more unsaturated groups in the form of monomers, oligomers or prepolymers are preferred.

In addition to monomers and/or oligomers, use can also be made of polymers comprising free-radical polymerizable C-C double bonds in the main or side chains.

It is of course possible to use different kinds of monomers, oligomers or polymers in admixture; furthermore, mixtures of monomers and oligomers and/or polymers can be used in the present invention, as well as mixtures of oligomers and polymers.

### Binders

Suitable optional binders are polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331).

Further suitable binders are "reactive binders", i.e. polymeric binders having side chains comprising free radical polymerizable groups. Suitable reactive binders are disclosed in a number of patent applications e.g. WO 2004/014652 A1, WO 89/06659 A1, DE 29 03 270 A1, WO 95/12147, EP 410 242, and US 4,035,321.

### NEGATIVE DIAZO-SYSTEMS (UV-SENSITlVE)

Another type of negative working UV-sensitive coating - applied onto a substrate - comprises a diazonium polycondensation product.

Diazonium polycondensation products known to the person skilled in the art can be used as diazonium polycondensation product. Such condensation products can for example be prepared according to known methods by condensing a diazo monomer described in EP-A-0 104 863 with a condensation agent such as formaldehyde, acetaldehyde, propionaldehyde, butyraldehyde, isobutyraldehyde or benzaldehyde. Furthermore, co-condensation products are used which in addition to the diazonium salt units also comprise other units which are not photosensitive and are derived from condensable compounds, in particular aromatic amines, phenols, phenol ethers, aromatic thiolethers, aromatic hydrocarbons, aromatic heterocycles and organic acid amides. Especially advantageous examples of the diazonium polycondensation products include reaction products of diphenylamine-4-diazonium salts, which optionally contain a methoxy group in the phenyl group carrying the diazo group, and formaldehyde or 4,4'-bismethoxymethyldiphenylether. Aromatic sulfonates such as 4-tolylsulfonate or mesitylene sulfonate, tetrafluoroborate, hexafluorophosphate, hexafluoroantimonate and hexafluoroarsenate are especially suitable as anions of these diazo resins. The diazonium polycondensation product is preferably present in an amount of 3 to 60 wt-% in the photosensitive composition.

Hybrid systems of diazonium polycondensation products and the above-mentioned UV-sensitive free-radical polymerizable system can also be used in the negative working radiation-sensitive coating.

Suitable optional binders for such systems are polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 5 to 95 wt-%, based on the dry layer weight, especially preferred 10 to 85 wt-%.

### SINGLE-LAYER NEGATIVE WORKING IR-SENSITIVE ELEMENTS

Another type of negative working single-layer IR-sensitive elements are elements wherein the radiation-sensitive layer on a substrate is rendered insoluble in or impenetrable by aqueous alkaline developer upon IR irradiation and comprises
(i) at least one compound which forms an acid upon the application of heat (in the following also referred to as "latent Bronsted acid"), and
(ii) a component cross-linkable by an acid (in the following also referred to as "cross-linking agent") or a mixture thereof and
(iii) at least one IR absorber.

Systems based on this principle are for example described in US 5,919,601, EP 0 625 728 B1 and EP 0 938 413 B1.

The IR absorbers can for example be selected from carbon black, phthalocyanine pigments/dyes and pigments/dyes of the polythiophene, squarylium, thiazolium, croconate, merocyanine, cyanine, indolizine, pyrylium or metaldithiolin classes, especially preferred from the cyanine class. The compounds mentioned in Table 1 of US 6,326,122 for example are suitable IR absorbers. Further examples can be found in US 4,327,169, US 4,756,993, US 5,156,938, WO 00/29214, US 6,410,207 and EP 1 176 007 A1.

According to one embodiment, a cyanine dye of formula (IX)
is used, wherein
- each Z¹: independently represents S, O, NR^{a} or C(alkyl)₂;
- each R': independently represents an alkyl group, an alkylsulfonate group or an alkylammonium group;
- R": represents a halogen atom, SR^{a}, OR^{a}, SO₂R^{a} or NR^{a}₂;
- each R''': independently represents a hydrogen atom, an alkyl group, -COOR^{a}, -OR^{a}, -SR^{a}, -NR^{a}₂ or a halogen atom; R''' can also be a benzofused ring;
- A⁻: represents an anion;
- R^{b} and R^{c}: either both represent hydrogen atoms or, together with the carbon atoms to which they are bonded, form a carbocyclic five- or six-membered ring;
- R^{a}: represents a hydrogen atom, an alkyl or aryl group;
- each b: is independently 0, 1, 2 or 3.

If R' represents an alkylsulfonate group, an internal salt can form so that no anion A⁻ is necessary. If R' represents an alkylammonium group, a second counterion is needed which is the same as or different from A⁻.

Of the IR dyes of formula (IX), dyes with a symmetrical structure are especially preferred. Examples of especially preferred dyes include:
2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(3,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium tosylate,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium tosylate and
2-[2-[2-chloro-3-[2-ethyl-(3H-benzthiazole-2-ylidene)-ethylidene]-1-cyclohexene-1-yl]-ethenyl]-3-ethyl-benzthiazolium tosylate.

The following compounds are also IR absorbers suitable for the present invention:

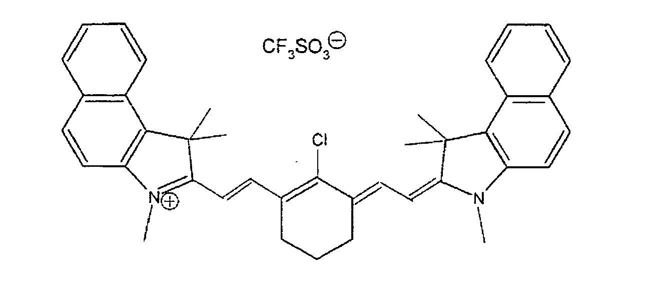

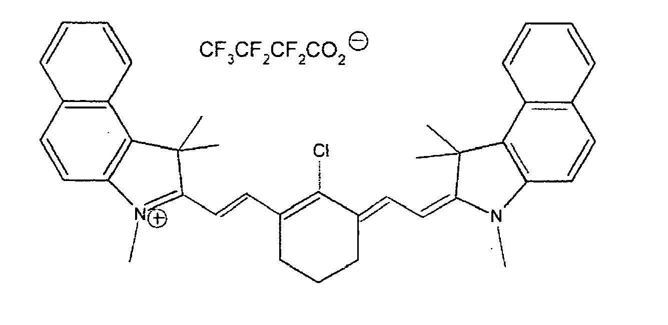

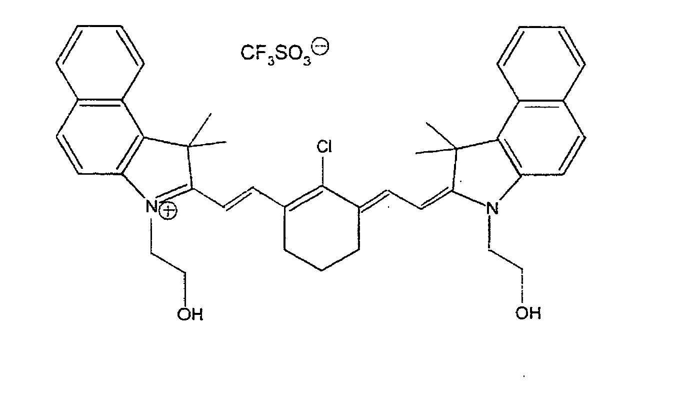

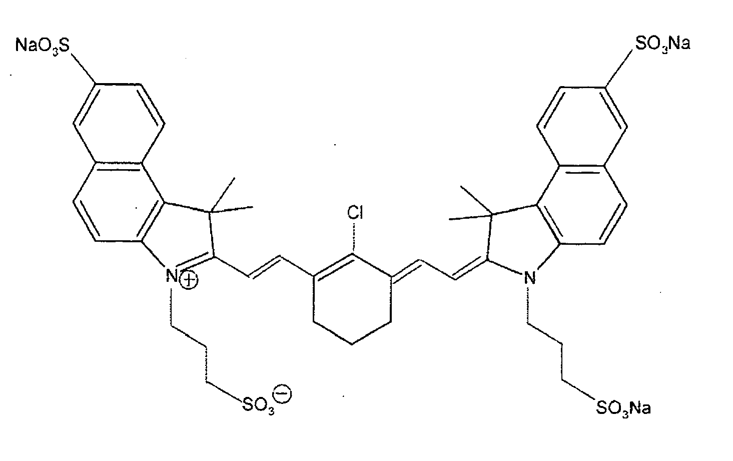

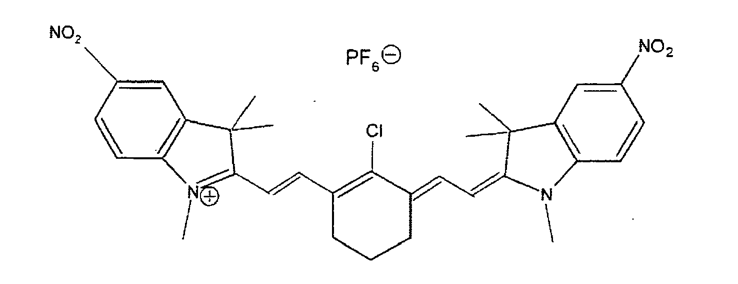

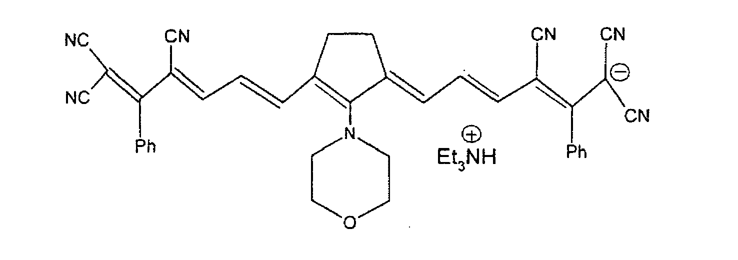

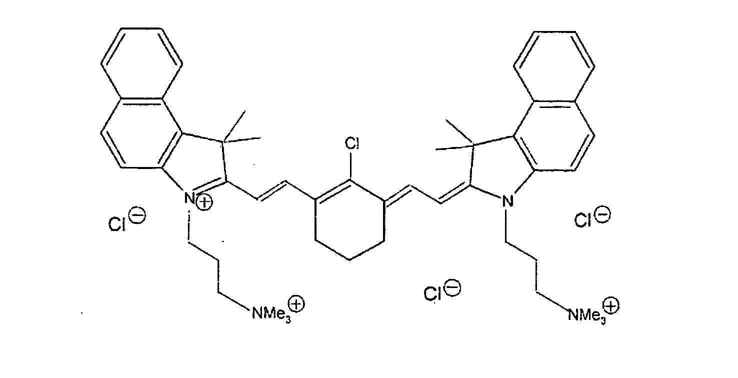

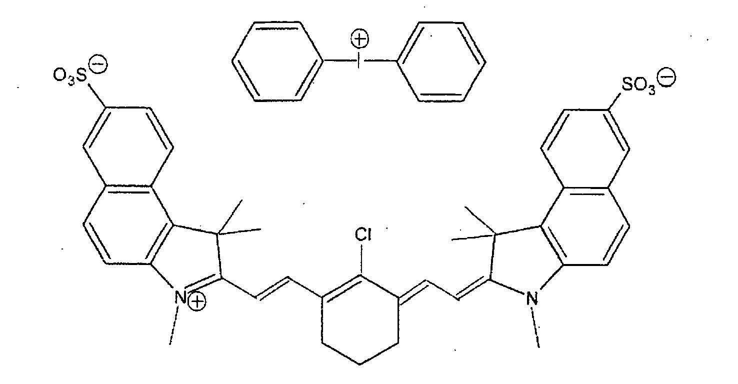

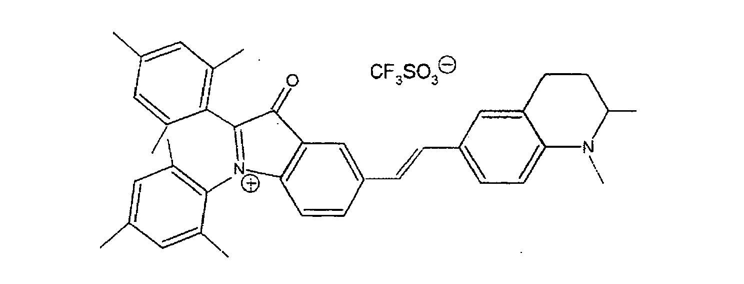

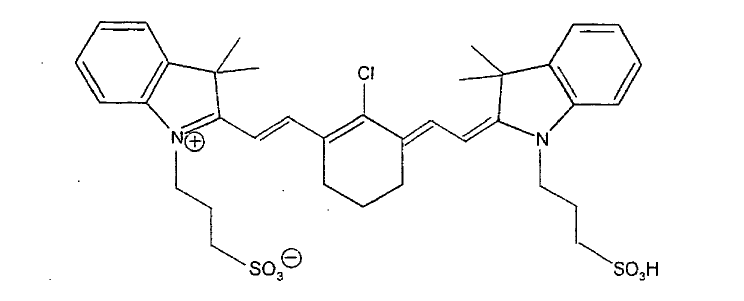

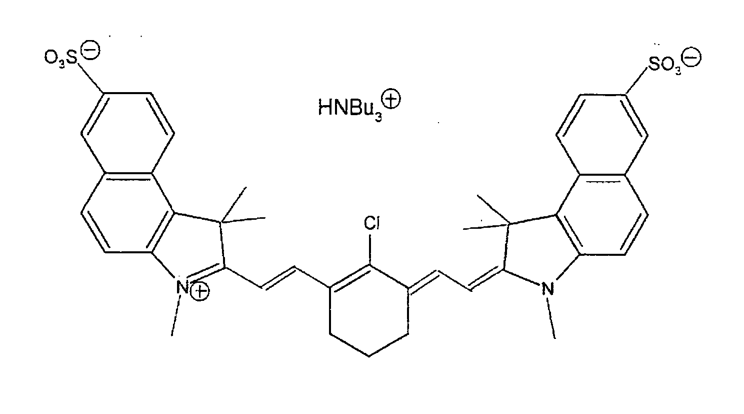

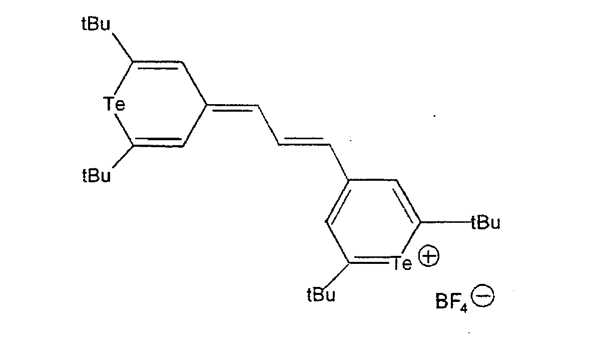

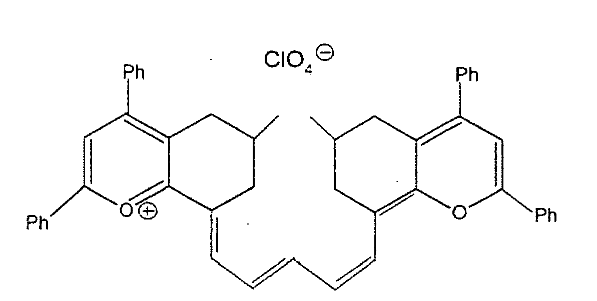

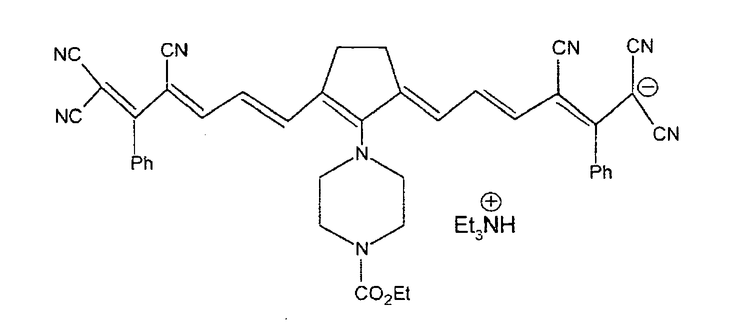

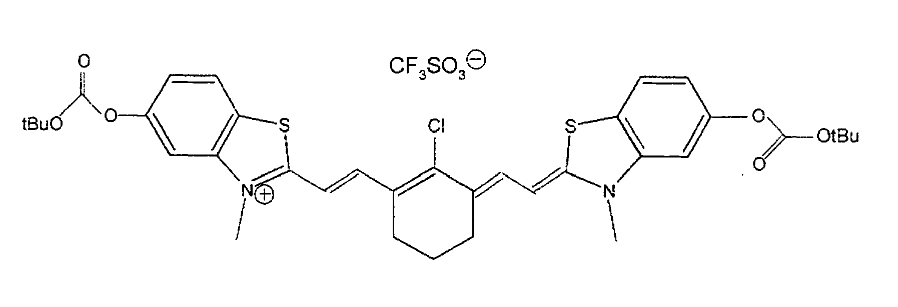

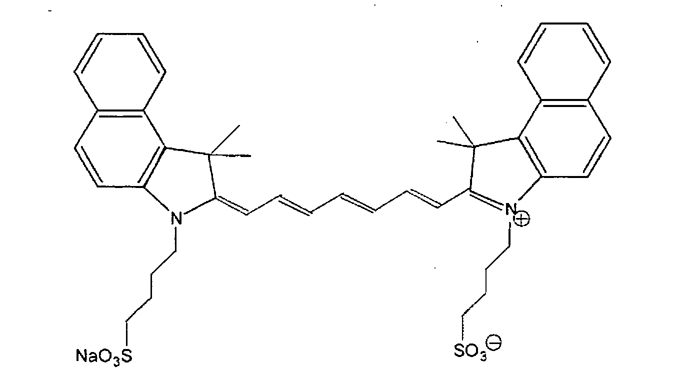

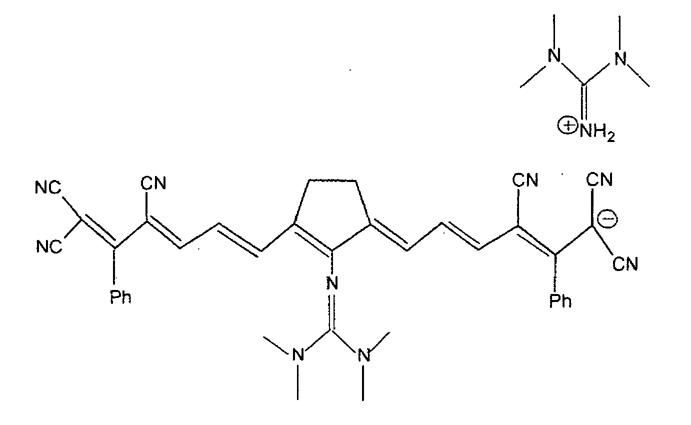

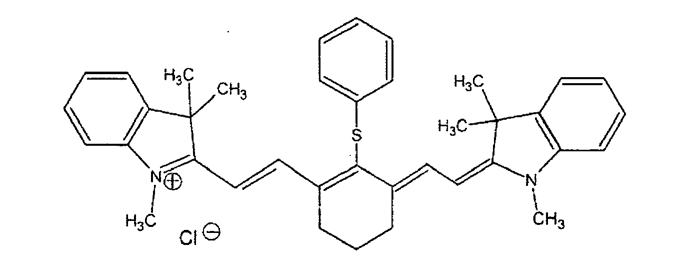

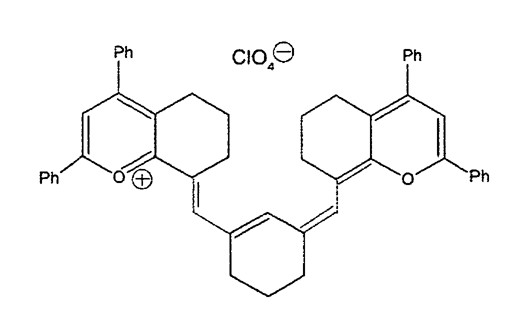

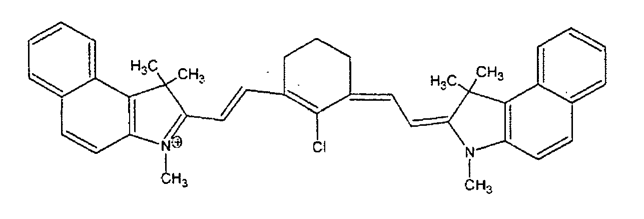

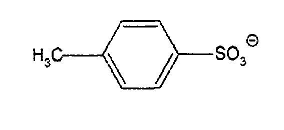

Ionic and nonionic Bronsted acids can be used as latent Bronsted acid. Examples of ionic latent Bronsted acids include onium salts, in particular iodonium, sulfonium, oxysulfoxonium, oxysulfonium, phosphonium, selenonium, telluronium, diazonium and arsonium salts. Specific examples are diphenyliodonium-hexafluorophosphate, triphenylsulfonium-hexafluoroantimonate, phenylmethyl-ortho-cyanobenzylsulfonium-tri-fluoromethanesulfonate and 2-methoxy-4-aminophenyl-diazonium-hexafluorophosphate.

Examples of nonionic latent Bronsted acids include RCH₂X, RCHX₂, RCX₃, R(CH₂X)₂ and R(CH₂X)₃, wherein X represents Cl, Br, F or CF₃SO₃ and R is an aromatic, aliphatic or araliphatic group.

Ionic latent Bronsted acids of the formula

X^{⊕}R^{1a}R^{1b}R^{1c} R^{1d}W^{Θ}

are also suitable, wherein if X represents iodine, R^{1c} and R^{1d} are free electron pairs and R^{1a} and R^{1b} are aryl groups or substituted aryl groups,
if X represents S or Se, R^{1d} is a free electron pair and R^{1a}, R^{1b}, R^{1c} are independently selected from aryl groups, substituted aryl groups, an aliphatic group or substituted aliphatic group,
if X represents P or As, R^{1d} can be an aryl group, substituted aryl group, aliphatic group or substituted aliphatic group, and
wherein W^{Θ} is selected from Br₄^{Θ}, CF₃SO₃^{Θ}, SbF₆^{Θ}, CCl₃CO₂^{Θ}, ClO₄^{Θ}, AsF₆^{Θ} or PF₆^{Θ}.

C₁-C₅-alkyl sulfonates, arylsulfonates (e.g. benzoin tosylate, 2-hydroxymethylbenzoin tosylate and 2,6-dinitrobenzyl tosylate) and N-C₁-C₅-alkyl-sulfonylsulfonamides (e.g. N-methanesulfonyl-p-toluene-sulfonamide and N-methanesulfonyl-2,4-dimethylbenzenesulfonamide) are also suitable.

Specific suitable onium compounds are for example listed in detail in US 5,965,319 as formulas (I) to (III).

The latent Bronsted acids are preferably used in an amount of 0.5 to 50 wt-%, especially preferred 3 to 20 wt-%, based on the dry layer weight.

The cross-linking agent can for example be a resin, selected from resols, C₁-C₅-alkoxymethylmelamines, C₁-C₅-alkoxymethyl-glycoluril resins, poly(C₁-C₅-alkoxy-methylstyrenes) and poly(C₁-C₅-alkoxymethylacrylamides), epoxidized novolak resins and urea resins. In particular, compounds comprising at least 2 groups in a molecule, selected from hydroxymethyl, alkoxymethyl, epoxy and vinylether groups, bonded to an aromatic ring, can be used as cross-linking agents; of those, phenol derivatives with at least 2 groups selected from hydroxymethyl and alkoxymethyl groups, bonded to a benzene ring, 3 to 5 benzene rings and a molecular weight of 1,200 or less, as listed in columns 31 to 37 of US 5,965,319, are preferred.

The cross-linking agent is preferably used in an amount of 5 to 90 wt-%, based on the dry layer weight, especially preferred 10 to 60 wt-%.

The radiation-sensitive layers of this type can contain binders, for example selected from alkalisoluble or dispersible (co)polymers, such as novolaks, acetone pyrogallol resin, polyhydroxystyrenes and hydroxystyrene-N-substituted maleimide-copolymers as listed in US 5,965,319 as component (C), polymers as mentioned in US 5,919,601 as binder resins and copolymers as described in DE 199 36 331.

In principle, known IR-sensitive elements with a single-layer structure, as for example described in US 5,919,601 and WO 00/17711 A1, can be processed according to the present invention.

### IR-SENSITIVE COALESCENCE ELEMENTS

This type of negative working IR-sensitive elements are elements wherein the coating on a substrate comprises particles which are able to coalesce upon application of heat. Usually an IR absorber converting IR-radiation into heat is also present in the coating, either in the same layer as the particles or in an adjacent layer. Optionally also a binder can be present in the coating.

The IR absorber can be any one described above for IR-sensitive single layer negative working elements.

The particles can be selected from hydrophilic thermoplastic polymer particles, particles with a core-shell-structure and microspheres containing an expanding agent.

The particles used in the coating which are able to coalesce upon application of heat can for instance be hydrophobic thermoplastic polymer particles like polystyrene, polyvinyl chloride, polymethyl methacrylate, polyvinylidene chloride, polyacrylonitrile, polyvinyl carbazole, copolymers and/or mixtures thereof. Such particles are for instance described in EP 0 770 497 A1. The hydrophobic thermoplastic polymer particles are typically dispersed in a hydrophilic binder like polyvinyl alcohol, poly(meth)acrylic acid, poly(meth)acrylamide, cellulose etc. as for instance mentioned in EP 0 770 497 A1. The particles may preferably have an average diameter of 0.01-50 µm, more preferably 0.05-10 µm and most preferably 0.05-2µm.

Suitable hydrophobic polymer particles are also described in EP 1 342 568 A1.

Another type of suitable particles are core-shell particles each of which comprising a water insoluble heat softenable core component A and a shell component B which is soluble or swellable in aqueous alkaline medium. Such core-shell particles including components A and B are for instance described in EP 0 514 145 A1.

Within the "coalescence embodiment" a particle coalescing upon exposure can also be a thermally expandable microsphere having a shell made of polymers and copolymers of acrylic acid, methacrylic acid, itconic acid, citraconic acid, maleic acid, fumaric acid, vinylbenzoic acid, esters, amides, nitriles such as acrylonitril and methacrylonitril, vinylaromatic compounds such as styrene, vinyl monomers such as vinyl chloride and vinyl aceteate, vinylidene compounds such as vinyl chloride and vinyl acetate, vinylidene compounds such as vinylidene chloride and dienes such as isoprene and butadiene. The shell contains a physically or chemically expanding agent.

Suitable shell polymers are for instance described in DE 699 20 664 T2, DE 693 12 160 T2 and WO 99/02589.

The expanding agent can be a volatile organic solvent or can be solid at room temperature. Suitable expanding agents are for instance described in US 2001/0044477 A1.

Processes for producing such thermally expandable microspheres are frequently described in the prior art like, e.g. US 2001/0044477 A1, EP 0 569 234 B1, WO 99/02589 A1, US 2005/0079352 A1 and EP 1 054 034 B1. They are also commercially available.

The expandable microspheres are dispersed in a hydrophilic polymeric binder like a phenolic resin, water-soluble cellulose derivative, carboxylic acid derivative of cellulose and (meth)acrylate polymers and copolymers. Suitable phenolic resins are for instance novolacs and resols; suitable carboxylic acid derivatives or cellulose are for instance described in EP 1 101 607 A1 in paragraphs [0024] to [0037] and in US 6,391,524 B2. Also suitable binders are the copolymers comprising N-substituted maleimide units which are described in WO 2005/018934, and the copolymers disclosed in US 5,731,127 B, US 5,141,838 B, EP 0 544 264 A1 and EP 0 737 896 A2.

### Positive working radiation-sensitive elements

### UV-SENSITIVE

Positive working UV-sensitive elements can for example be based on quinone diazides (preferably naphthoquinone diazides) and novolaks, as for example described in US 4,594,306.

Suitable binders for such coatings are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 5 to 95 wt-%, based on the dry layer weight, especially preferred 10 to 85 wt-%.

### IR-SENSITIVE

There are numerous examples of positive working IR-sensitive elements, which can be divided into two groups: those with a radiation-sensitive coating comprising only one layer and those where the radiation-sensitive coating comprises at least two layers.

### Single-layer plates

Usually, single-layer positive working IR-sensitive elements comprise
(a) an optionally pretreated substrate
(b) a positive working heat-sensitive layer comprising
   (i) at least one polymer soluble in aqueous alkaline developer, such as e.g. a novolak resin,
   (ii) at least one component which reduces the aqueous alkaline developer solubility of the developer soluble polymer (e.g. novolak), wherein said reduction in solubility is reversed upon the application of heat ("insolubilizer"), and
   (iii) optionally an IR absorber (i.e. a compound which absorbs IR radiation and converts it to heat),
wherein components (i) and (ii) do not have to be present as separate substances but can be used in the form of an accordingly functionalized novolak. It is also possible to use an IR absorber that also acts as insolubilizer. Such single-layer IR-sensitive positive working elements are for example described in EP 825 927 B1.

Polymers with hydroxyl, carboxylic acid, amino, amide and maleimide groups can for example be used as polymers soluble in aqueous alkaline developer. In particular, these compounds include phenolic resins, copolymers of 4-hydroxystyrene and 3-Methyl-4-hydroxystyrene or 4-methoxystyrene, copolymers of (meth)acrylic acid and styrene, copolymers of maleimides and styrene, hydroxy- or carboxy-functionalized celluloses, copolymers of maleic acid anhydride and styrene and partially hydrolyzed polymers of maleic acid anhydride. Phenolic acids, in particular novolak, are especially preferred.

Suitable novolak resins are condensation products of phenols, e.g. phenol itself, C-alkyl-substituted phenols (including cresols, xylenols, p-tert-butylphenol, p-phenylphenol and nonyl phenols) and diphenols (e.g. bisphenol-A), with suitable aldehydes such as formaldehyde, acetaldehyde, propionaldehyde, and furfuraldehyde. The type of catalyst and the molar ratio of the reactants determine the molecular structure and thus the physical properties of the resin. An aldehyde/phenol ratio of about 0.5:1 to 1:1, preferably 0.5:1 to 0.8:1, and an acid catalyst are used in order to produce those phenolic resins known as "novolaks" and having a thermoplastic character. However, as used in the present application, the term "novolak resin" should also encompass the phenolic resins known as "resols" which are obtained at higher aldehyde/phenol ratios and in the presence of alkaline catalysts.

Based on the dry layer weight, the novolak resin is preferably present in an amount of at least 40 wt-%, more preferred at least 50 wt-%, even more preferred at least 70 wt-% and particularly preferred at least 80 wt-%. Usually, the amount does not exceed 95 wt-%, more preferred wt-%.

The chemical structure of the IR absorber is not particularly restricted as long as it is capable of converting the absorbed radiation into heat. The IR absorbers mentioned above in connection with single layer negative working IR-sensitive elements can be used. The IR absorber is preferably present in an amount of at least 0.1 wt-% based on the dry layer weight, more preferred at least 1 wt-%, and particularly preferred at least 2 wt-%. Usually, the amount of IR absorber does not exceed 25 wt-%, more preferred 20 wt-% and particularly preferred 15 wt-%. Either a single IR absorber or a mixture of two or more can be present; in the latter case, the amounts given refer to the total amount of all IR absorbers.

The amount of IR absorber to be used also has to be considered in view of the dry layer thickness of the coating. It should preferably be selected such that the optical density of the coating - measured for example on a transparent polyester film - preferably shows values between 0.4 and 1.0 at the wavelength of the IR light with which the coating is irradiated.

The IR-sensitive coating furthermore comprises at least one substance that reduces the aqueous alkaline developer solubility of the polymer like novolak, whereby this reduction in solubility is reversed by the application of heat. In the following, this substance is briefly referred to as "insolubilizer". The insolubilizer may or may not be covalently bonded to a polymer.

Use can be made of insolubilizers already described in the prior art or of different ones.

Suitable insolubilizers include for example the compounds described in WO 98/42507 and EP-A 0 823 327 which are not photosensitive and comprise functional groups that can enter into a hydrogen bond with the phenolic OH groups of novolak resins. WO 98/42507 mentions sulfone, sulfoxide, thion, phosphinoxide, nitrile, imide, amide, thiol, ether, alcohol, urea, nitroso, azo, azoxy and nitro groups, halogens and in particular keto groups as suitable functional groups. Xanthone, flavanone, flavone, 2,3-diphenyl-1-indenone, pyrone, thiopyrone and 1'-(2'-acetonaphthonyl)benzoate are mentioned as examples of suitable compounds.

In WO 99/01795, polymers with specific functional groups Q which preferably do not comprise diazide groups, acid groups or acid-forming groups are used as insolubilizers, and according to a preferred embodiment, Q is selected from amino, monoalkylamino, dialkylamino, amido, monoalkylamido, dialkylamido groups, fluorine atoms, chlorine atoms, carbonyl, sulfinyl or sulfonyl groups. These polymeric insolubilizers can also be used in the present invention.

The insolubilizers described in WO 99/01796, in this case compounds with diazide units, can be used in the present invention as well.

Another group of insolubilizers suitable for use in the present invention is described in WO 97/39894. They are e.g. nitrogen-containing compounds wherein at least one nitrogen atom is quaternized and forms part of a heterocyclic ring; examples include e.g. quinolinium compounds, benzothiazolium compounds and pyridinium compounds, and in particular cationic trimethylmethane dyes such as Victoria Blue (C I Basic Blue 7), crystal violet (C I Basic Violet 3) and ethyl violet (C I Basic Violet 4). Furthermore, compounds with carbonyl function such as N-(4-bromobutyl)-phthalimide, benzophenone and phenanthrenequinone are mentioned. Compounds of the formula Q₁-S(O)ₙ-Q₂ (wherein Q₁ = optionally substituted phenyl or alkyl group; n = 0, 1 or 2; Q₂ = halogen atom or alkoxy group), Acridine Orange Base and ferrocenium compounds can be used as well.

If the IR absorbers comprise the structural elements mentioned in WO 97/39894, they also function as insolubilizers.

The functionalized novolaks described in US 6,320,018 B can be used in the heat-sensitive elements of the present invention as well. These novolaks contain substituents which allow a two- or four-center hydrogen bond (preferably a four-center hydrogen bond, also named quadrupol hydrogen bonding QHB) between the polymer molecules. This also decreases the aqueous alkaline developer solubility of the underlying novolak. Such hydrogen bonds are broken by heating and the original solubility of the novolak is restored. If such a functionalized novolak is used, it assumes the function of components (i) and (ii) of the heat-sensitive composition so that the additional use of a novolak without corresponding functional groups and/or an insolubilizer as described above is not necessary, but not excluded, either.

The functionalized novolaks comprise at least one covalently bonded unit and at least one non-covalently bonded unit, with the non-covalent bond being thermally unstable; these novolaks have a two- or four-center hydrogen bond at essentially every non-covalently bonded unit. A preferred group of such functionalized novolaks which can be used as novolak with a simultaneous insolubilizing function can be described with the following formula (XIV): 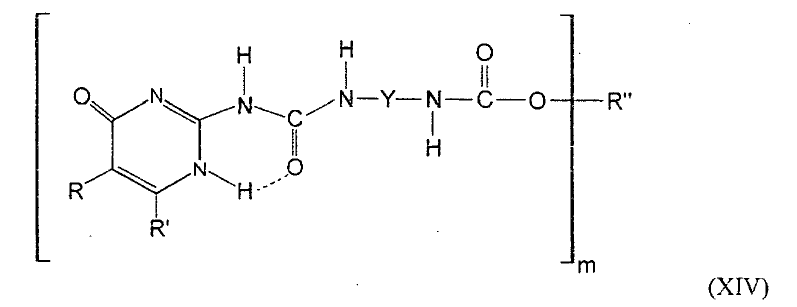 wherein R and R' are independently selected from a hydrogen atom and a cyclic or straight or branched saturated or unsaturated hydrocarbon group with preferably 1 to 22 carbon atoms (preferably hydrogen and C₁-C₄ alkyl), R" is a phenolic group derived from a novolak R"(OH)ₚ, Y is a divalent cyclic or straight or branched saturated or unsaturated hydrocarbon group with preferably 1 to 22 carbon atoms derived from a diisocyanate of the formula Y(NCO)₂ (e.g. isophorone diisocyanate, toluene-1,2-diisocyanate, 3-isocyanatomethyl-1-methylcyclohexylisocyanate), m is at least 1 and p is 1 or 2.

The preparation of functionalized novolaks of formula (XIV) can e.g. be inferred from US 2002/0,150,833 A1.

Another class of suitable functionalized resins, such as e.g. functionalized phenolic resins and in particular functionalized novolaks, is disclosed in US 6,537,735 B. While the non-functionalized resin is soluble in aqueous alkaline developer, the functionalized resin is insoluble in the developer; however, the application of heat (for example generated by IR radiation) renders it soluble in the developer. Preferably, the non-functionalized resin comprises OH or SH groups which in the functionalized resin are at least partially converted to covalently bonded functional groups Q; preferably, the functional groups Q are formed via an esterification reaction of the OH groups and are preferably selected from -O-SO₂-tolyl, -O-dansyl, -O-SO₂-thienyl, -O-SO₂-naphthyl and -O-CO-phenyl. The ratio of functional groups Q to OH groups is preferably 1:100 to 1:2, more preferred 1:50 to 1:3. The novolak resins, resols, acrylic resins with phenolic side chains and hydroxystyrenes described above can for example be used as non-functionalized resins. An especially preferred functionalized resin of this class is a phenolic resin (preferably a novolak), partially (e.g. 10 to 20%) esterified with toluenesulfonic acid or sulfonic acid chloride; however, all the other functionalized resins described in US 6,537,735 can be used in the present invention as well.

Although all the insolubilizers mentioned above can be used in the heat-sensitive coating of the present invention, the following are preferred: Cyanine dyes, triarylmethane dyes, quinolinium compounds, the above insolubilizers with (a) keto group(s) and the above insolubilizers with (a) sulfone group(s), as well as novolaks functionalized with substituents capable of forming four-center hydrogen bonds. The cyanine dyes, triarylmethane dyes, quinolinium compounds, ketones and sulfones can be used as low-molecular substances or bonded to a polymer.

A single insolubilizer or mixtures of two or more compounds can be used in the heat-sensitive elements of the present invention.

The amount of insolubilizer(s) is not particularly restricted as long as it reduces the aqueous alkaline developer solubility of the novolak. However, the solubility reduction has to take place to such an extent that when an aqueous alkaline developer is used, the heated areas of the coating are removed considerably faster than the non-heated areas.

Independently of whether the insolubilizer also functions as IR absorber, it is preferably present in an amount of at least 0.1 wt-% based on the dry layer weight, more preferred at least 0.5 wt-%, especially preferred at least 1 wt-% and particularly preferred at least 2 wt-%. Preferably, no more than 25 wt-%, more preferred no more than 15 wt-%, are used.

Optional binders are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 1 to 99 wt-%, based on the dry layer weight, especially preferred 10 to 98 wt-%.

### Dual-layer plates

IR sensitive elements useful in the present invention can also be positive working dual-layer elements wherein an inner layer (also referred to as "first layer" or "bottom layer") is provided on the hydrophilic surface of the substrate which is soluble in aqueous alkaline developer and a top layer ("masking layer") on top of the first layer.

The inner layer comprises a first polymeric binder that is removable by the developer and typically soluble in the developer to reduce sludging of the developer. In addition, the first polymeric binder is usually insoluble in the solvent used to coat the outer layer so that the outer layer can be coated over the inner layer without dissolving the inner layer. Mixtures of these first polymeric binders can be used if desired in the inner layer. This first polymeric binder can be for the inner layer include (meth)acrylonitrile polymers, (meth)acrylic resins comprising carboxy groups, polyvinyl acetals, maleated wood rosins, styrene-maleic anhydride copolymers, (meth)acrylamide polymers including polymers derived from N-alkoxyalkyl methacrylamide, polymers derived from an N-substituted cyclic imide, polymers having pendant cyclic urea groups, and combinations thereof. Still other useful polymeric binders include polymers derived from an N-substituted cyclic imide (especially N-phenylmaleimide), a (meth)acrylamide (especially methacrylamide), a monomer having a pendant cyclic urea group, and a (meth)acrylic acid (especially methacrylic acid). Polymeric binders of this type include copolymers that comprise from about 20 to about 75 mol % and typically about 35 to about 60 mol % or recurring units derived from N-phenylmaleimide, N-cyclohexyl-maleimide, N-(4-carboxyphenyl)maleimide, N-benzylmaleimide, or a mixture thereof, from about 10 to about 50 mol % of recurring units derived from acrylamide, methacrylamide, or a mixture thereof, and from about 5 to about 30 mol % of recurring units derived from methacrylic acid. Other hydrophilic monomers, such as hydroxyethyl methacrylate, may be used in place of some or all of the methacrylamide. Other alkaline soluble monomers, such as acrylic acid or 5-Methacrylamido-1,2,3,4-tetrazole, may be used in place of some or all of the methacrylic acid. Optionally, these polymers can also include recurring units derived from (meth)acrylonitrile or N-[2-(2-oxo-1-imidazolidinyl)ethyl]-methacrylamide.

Still other useful polymeric binders for the inner layer can comprise, in polymerized form, from about mol % to about 30 mol % of recurring units derived from an ethylenically unsaturated polymerizable monomer having a carboxy group (such as acrylic acid, methacrylic acid, itaconic acid, and other similar monomers known in the art (acrylic acid and methacrylic acid are preferred), from about 20 mol % to about 75 mol % of recurring units derived from N-phenylmaleimide, N- cyclohexylmaleimide, or a mixture thereof, optionally, from about 5 mol % to about 50 mol % of recurring units derived from methacrylamide, and from about 3 mol % to about 50 mol % one or more recurring units derived from monomer compounds of the following Structure:

CH₂=C(R₂)-C(=O)-NH-CH₂-OR₁

wherein R₁ is a C₁ to C₁₂ alkyl, phenyl, C₁ to C₁₂ substituted phenyl, C₁ to C₁₂ aralkyl, or Si(CH₃)₃, and R₂ is hydrogen or methyl, as described for example in U.S. Patent 7,186,482 (Kitson et al.). Methods of preparation of certain of these polymeric materials are disclosed in U.S. Patent 6,475,692 (Jarek).

Additional useful polymeric binders for the inner layer are described for example, in U.S. Patents 7,144,661 (Ray et al.), US 2007/0269727 (Savariar-Hauck et al), and 7,223,506 (Kitson et al.), and U.S. Patent Application Publications 2006/0257764 (Ray et al.) and 2007/0172747 (Ray et al.).

The additional polymeric binders can comprise more than 50% and up to 100% (dry weight) of the total polymeric materials in the inner layer. Still other useful additional polymeric materials include copolymers that comprises from about 1 to about 30 mole % of recurring units derived from N-phenylmaleimide, from about 1 to about 30 mole % of recurring units derived from methacrylamide, from about 20 to about 75 mole % of recurring units derived from acrylonitrile, and from about 20 to about 75 mole % of recurring units derived from one or more monomers of the Structure (XI):

CH₂=C(R₂₃)-CO₂-CH₂CH₂-NH-CO-NH-*p*-C₆H₄-R₂₂ (XI)

wherein R₂₂ is OH, COOH, or SO₂NH₂, and R₂₃ is H or methyl, and, optionally, from about I to about 30 mole % from about 3 to about 20 mole % of recurring units derived from one or more monomers of the Structure (XII):

CH₂-C(R₂₅)-CO-NH-p-C₆H₄-R₂₄ (XII)

wherein R₂₄ is OH, COOH, or SO₂NH₂, and R₂₅ is H or methyl.

The inner layer may also comprise one or more secondary additional polymeric materials that are resins having activated methylol and/or activated alkylated methylol groups. The secondary additional polymeric materials can include, for example resole resins and their alkylated analogs, methylol melamine resins and their alkylated analogs (for example melamine-formaldehyde resins), methylol glycoluril resins and alkylated analogs (for example, glycoluril-formaldehyde resins), thiourea-formaldehyde resins, guanamine-formaldehyde resins, and benzoguanamine-formaldehyde resins. Commercially available melamine-formaldehyde resins and glycoluril-formaldehyde resins include, for example, CYMEL^{®} resins (Dyno Cyanamid) and NIKALAC^{®} resins (Sanwa Chemical). The resin having activated methylol and/or activated alkylated methylol groups is typically a resole resin or a mixture of resole resins. Resole resins are well known to those skilled in the art. They are prepared by reaction of a phenol with an aldehyde under basic conditions using an excess of phenol. Commercially available resole resins include, for example, GP649D99 resole (Georgia Pacific) and BKS-5928 resole resin (Union Carbide). Useful secondary additional polymeric materials can also include copolymers that comprise from about 25 to about 75 mole % of recurring units derived from N-phenylmaleimide, from about 10 to about 50 mole % of recurring units derived from methacrylamide, and from about 5 to about 30 mole % of recurring units derived from methacrylic acid. These secondary additional copolymers are disclosed in U.S. Patents 6,294,311 (Shimazu et al.) and 6,528,228 (Savariar-Hauck et al.). The inner layer may also comprise a polymer having pendant 1H-tetrazole groups generally present in an amount of at least 10 weight %, and generally from about 60 to 95 weight % of the total dry inner layer weight.

An IR absorber ("photothermal conversion material") is present in the first layer, or the top layer or in both layers; it can also be present in a separate "absorber layer". Preferably the IR absorber is present in the first layer.

The chemical structure of the IR absorber is not particularly restricted as long as it is capable of converting the absorbed IR radiation into heat. The IR absorbers mentioned above for single layer negative working IR-sensitive elements can be used. The IR absorber is preferably present in an amount of at least 1 wt-% based on the dry layer weight of the layer in which it is present, more preferred at least 2 wt-%, and particularly preferred at least 5 wt-%. Usually, the amount of IR absorber does not exceed 35 wt-%, more preferred 30 wt-% and particularly preferred 25 wt-% of the layer in which it is present. If the IR absorber is only present in the first layer, its amount in said layer is preferably from 10 to 20 wt-%, based on the dry layer weight of the first layer. Either a single IR absorber or a mixture of two or more can be present; in the latter case, the amounts given refer to the total amount of all IR absorbers present in one layer.

The top layer protects the first layer from being dissolved by an aqueous alkaline developer. It is therefore necessary that the top layer itself is not soluble or dispersible in or penetrable by an aqueous alkaline developer. By the wording "not soluble in, dispersible in or penetrable by an aqueous alkaline developer", it is meant that the top layer can resist the attack of an aqueous alkaline developer having a pH of at least 8 for at least 90 seconds. However, upon exposure to IR radiation the top layer becomes removable by an aqueous alkaline developer (necessary dwell time: less than 60 seconds).

Various dual-layer plates are known in the art, however, the mechanisms of change of solubility/dispersibility/penetrability due to exposure to IR radiation are still not fully understood. Such dual-layer systems are for instance described in US 6,352,812, US 6,352,811, US 6,358,669, US 2002/0,150,833 A1, US 6,320,018, US 6,537,735 and WO 02/14071.

According to one embodiment the top layer (also referred to in the following as "masking layer") may be insoluble in the aqueous alkaline developer and be made penetrable to the developer after imaging. The removed mask remains insoluble in the developer. Polymers such as nitrocellulose and polymethylmethacrylate are examples of such cases are described in US 6352812.

In another embodiment, the masking layer may show a slower rate of solubility in the developer than the first layer enabling sufficient protection of the image areas during the development stage. This is achieved by the use of polymers in the top layer with low acid numbers which enables solubility in the developer but at a slower rate than the inner layer. For this purpose top layer polymers may have pendant carboxyl, carboxy anhydride, sulfonamide, sulfonic acid, phosphonic acid, or phosphoric acid and tetrazole groups and may be obtained by reaction with suitable one or more monmers such as allyl (meth)acrylates, alkyl (meth)acrylates, hydroxyalkyl (meth)acrylates, (meth)acrylamides that can be substituted by alkyl or aryl groups, (meth)acrylates of polyethylene oxide or propylene oxide, (meth)acrylonitriles, styrene or styrene derivatives, vinyl acetate, vinyl carbazole, vinyl pyrrolidone, vinyl alcohol, N-substituted maleimides, or half esters of ring-opened maleic acid anhydrides. Other monomers from which B recurring units can be derived would be readily apparent to a skilled artisan. Polymers with pendant acid groups can also be obtained by condensation reactions such as described in US 7,241,556.

Phenolic resins are generally insoluble in low pH developers of about pH 10. However phenolic resins functionalised with carboxylic groups or phenolic resins of low molecular weight condensates have been found to dissolve in low pH developers but at a slower rate than the first layer and therefore can also be used as top layers for dual layer plates developable in low pH developer.

A slower solubility rate of solubility in the developer of the masking layer than the first layer may also be achived by using polymers in the top layer which undergo slow hydrolysis and then become soluble in the developer. Examples of such polymers are styrene maleic anhydride copolymers.

According to another embodiment top layers can also be made to resist developer attack through inhibition of phenolic resins and are rendered soluble in the developer by "deinhibition" upon IR irradiation.

Suitable phenolic resins include e.g. novolaks, resols, acrylic resins with phenolic side chains and polyvinyl phenolic resins, whereby novolaks are especially preferred. Novolak resins are condensation products of suitable phenols, e.g. phenol itself, C-alkyl-substituted phenols (including cresols, xylenols, p-tert-butylphenol, p-phenylphenol and nonylphenols), and of diphenols (e.g. bisphenol-A), with suitable aldehydes such as formaldehyde, acetaldehyde, propionaldehyde and furfuraldehyde. The type of catalyst and the molar ratio of the reactants determine the molecular structure and thus the physical properties of the resin. An aldehyde/phenol ratio of about 0.5:1 to 1:1, preferably 0.5:1 to 0.8:1, and an acid catalyst are used in order to produce those phenolic resins known as "novolaks" which have a thermoplastic character. As used in the present application, however, the term "novolak resin" should also encompass the phenolic resins known as "resols" which are obtained at higher aldehyde/phenol ratios and in the presence of alkaline catalysts.

One type of such top layers comprises for example a polymer like a novolak which itself is soluble/dispersible in an aqueous alkaline developer and an "insolubilizer" which reduces the solubility/dispersibility to such a high degree that the layer is not soluble or penetrable under developing conditions. The interaction between the polymer and the inhibitor is deemed to be weakened by IR radiation to such a degree that the irradiated (heated) areas of the layer are rendered soluble/dispersible in or penetrable by the developer. Such systems are for example described in US 6,352,811 and US 6,358,669. The polymer/insolubilizer systems can be the same as those described above for single layer plates.

The amount of insolubilizer(s) in the top layer is not particularly restricted as long as it reduces the aqueous alkaline developer solubility of the novolak. However, the solubility reduction has to take place to such an extent that when an aqueous alkaline developer is used, the heated areas of the coating are removed considerably faster than the non-heated areas. The insolubilizer is preferably present in an amount of at least 0.1 wt-% based on the dry layer weight, more preferred at least 0.5 wt-%, especially preferred at least 2 wt-% and particularly preferred at least 5 wt-%. Preferably, no more than 40 wt-%, more preferred no more than 25 wt-%, are used.

Another type of such top layers may comprise a polymer like a novolak which as such is soluble/dispersible in an aqueous alkaline developer but which has been chemically modified (for instance by chemically binding an "insolubilizer") so that it is not soluble/dispersible/penetrable by an aqueous alkaline developer. Such functionalized resins (like e.g. functionalized novolaks) are for instance described in US 2002/0,150,833 A1, US 6,320,018 B and US 6,537,735 B.

It is assumed that either there are any interactions within the top layer which are weakened by IR radiation or microcracks and/or bubbles are formed in the top layer or in the interface between first layer and top layer due to exposure to IR radiation (and the heat created thereby) which allows removal of the initially insoluble/inpenetrable top layer together with the soluble bottom layer by the developer in the exposed areas enabling the developer to penetrate and remove the imaged areas which also ultimately dissolve in the developer.

Chemically modified polymers useful for the top layer are for instance functionalized novolaks like those of formula (XIV) mentioned above and functionalized phenolic resins like those mentioned in US 6,537,735 B (e.g. tosylated novolaks), see also above under the headline "Single-layer plates". Modified alkylphenol resins (like those commercially available from Schenectady under the trade name SP1077 and HRJ302) as well as novolaks based on xylenol and cresol (like those commercially available from AZ-Electronics under the trade name SPN-572) are also useful for a top layer.

Other useful polymeric binders for the top layer include polyvinyl compounds having phenolic hydroxyl groups, including poly(hydroxystyrenes) and copolymers containing recurring units of a hydroxystyrene and polymers and copolymers containing recurring units of substituted hydroxystyrenes. Also useful are branched poly(hydroxystyrenes) having multiple branched hydroxystyrene recurring units derived from 4-hydroxystyrene as described for example in U.S. Patents 5,554,719 (Sounik) and 6,551,738 (Ohsawa et al.), and U.S. Published Patent Applications 2003/0050191 (Bhatt et al.) and 2005/0051053 (Wisnudel et al.), and in copending and commonly assigned U.S. Patent Application Serial No. 11/474,020 (filed June 23, 2006 by Levanon et al.). For example, such branched hydroxystyrene polymers comprise recurring units derived from a hydroxystyrene, such as from 4-hydroxystyrene, which recurring units are further substituted with repeating hydroxystyrene units (such as 4-hydroxystyrene units) positioned ortho to the hydroxy group. These branched polymers can have a weight average molecular weight (M_{w}) of from about 1,000 to about 30,000, or typically from about 1,000 to about 10,000, and more typically from about 3,000 to about 7,000. In addition, they may have a polydispersity less than 2 and preferably from about 1.5 to about 1.9. The branched poly(hydroxystyrenes) can be homopolymers or copolymers with non-branched hydroxystyrene recurring units.

One group of useful polymeric binders for the top layer include poly(vinyl phenol) and derivatives thereof. Such polymers are obtained generally by polymerization of vinyl phenol monomers, that is, substituted or unsubstituted vinyl phenols. Substituted vinyl phenol recurring units include those described below for the "a" recurring units in Structure (A). Some vinyl phenol copolymers are described in EP 1,669,803A (Barclay et al.).

Other useful polymeric binders for the top layer are modified novolak or resole resins that are represented by Structure (B) 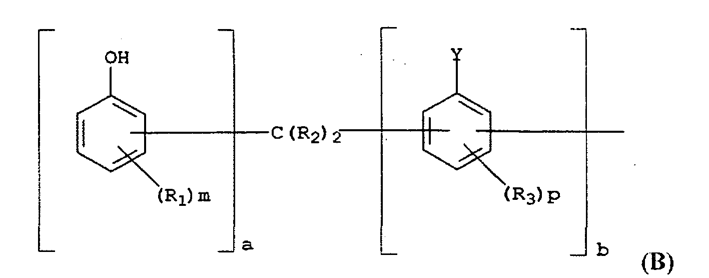 wherein
Y is 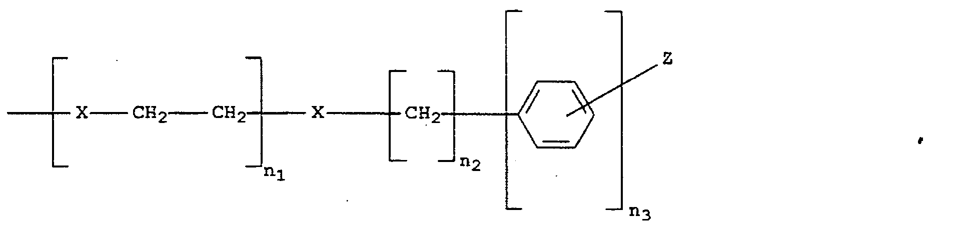 a is from about 90 to about 99 mol % (typically from about 92 to about 98 mol %) based on the total polymer, b is from about 1 to about 10 mol % (typically from about 2 to about 8 mol %), R₁ and R₃ are independently hydrogen or hydroxy, alkyl, or alkoxy groups, R₂ is hydrogen or an alkyl group, X is an alkylene, oxy, thio, -OC(=O)Ar-, -OC(=O)CH=CH-, or -OCO(CH₂)ₙ₄- group wherein Ar is an aryl group, m and p are independently 1 or 2, n₃ is 0 or an integer up to 5 (for example 0, 1, 2, or 3), n₂ is 0 or an integer up to 5 (for example, 0, 1, or 2), n₃ is 0 or 1 (typically 0), n₄ is at least 1 (for example, up to 8), and Z is -C(=O)OH, -S(=O)₂OH, -P(=O)(OH)₂, or -OP(=O)(OH)₂.

The alkyl and alkoxy groups present in the polymeric binders (for R¹, R², and R³) can be unsubstituted or substituted with one or more halo, nitro, or alkoxy groups, and can have 1 to 3 carbon atoms. Such groups can be linear, branched, or cyclic (that is, "alkyl" also include "cycloalkyl" for purposes of this invention).

When X is alkylene, it can have 1 to 4 carbon atoms and be further substituted similarly to the alkyl and alkoxy groups. In addition, the alkylene group can be a substituted or unsubstituted cycloalkylene group having at least 5 carbon atoms in the ring and chain. Ar is a substituted or unsubstituted, 6 or 10-membered carbocyclic aromatic group such as substituted or unsubstituted phenyl and naphthyl groups. Typically, Ar is an unsubstituted phenyl group.

In some embodiments, the polymeric binder of the top layer comprises recurring units represented by Structure (B) wherein a is from about 92 to about 98 mol %, b is from about 2 to about 8 mol % and Z is -C(=O)OH, and is present at a dry coverage of from about 15 to 100 weight % based on the total dry weight of the layer.

Other polymeric binders that may be in the top layer include phenolic resins such as novolak and resole resins, which include one or more pendant diazo, carboxylate ester, phosphate ester, sulfonate ester, sulfinate ester, or ether groups. The hydroxy groups of the phenolic resins can be converted to -T-Z groups in which T represents a polar group and Z represents a non-diazide functional group as described for example in U.S. Patent 6,218,083 (McCullough et al.) and WO 99/001795 (McCullough et al.). The hydroxy groups can also be derivatized with diazo groups containing o-naphthoquinone diazide moieties as described for example in U.S. Patents 5,705,308 (West et al.) and 5,705,322 (West et al.). Other useful polymeric binders include acrylate copolymers as described for example in EP 737,896A (Ishizuka et al.), poly(vinyl acetals) as described for example in WO 2005/039878 (Savariar-Hauck et al) DE 10 239 505 (Timpe et al.) and WO 2004081662 (Memetea et al.) and cellulose esters described in U.S. Patent 6,391,524 (Yates et al.).

Still other useful polymeric binders for the top layer are described for example, in U.S. Patents 7,163,770 (Saraiya et al.) and 7,160,653 (Huang et al.).

The polymeric binder(s) can preferably be present in the top layer at a dry coverage of from about 15 to 100 wt-% (more preferably from about 30 to about 95 wt-%) based on the total dry top layer weight in those cases where no insolubilizer is present in the top layer; if an insolubilizer is present in the top layer, the polymeric binder(s) can be present preferably up to 99.9 wt-%, more preferably up to 99.5 wt-%, especially up to 98 wt-% and most preferably up to 95 wt-%.

### Optional components

Independently of whether the element is UV/VIS- or IR-sensitive, the radiation-sensitive coating can comprise one or more of the following optional components in addition to the essential components. If the coating consists of several layers, the optional component(s) can be present in one, several or all of the layers.

Dyes or pigments having a high absorption in the visible spectral range can be present in order to increase the contrast ("contrast dyes and pigments"). Particularly suitable dyes and pigments are those that dissolve well in the solvent or solvent mixture used for coating or are easily introduced in the disperse form of a pigment. Suitable contrast dyes include *inter alia* rhodamine dyes, triarylmethane dyes such as Victoria blue R and Victoria blue BO, crystal violet and methyl violet, anthraquinone pigments, azo pigments and phthalocyanine dyes and/or pigments. The colorants are preferably present in an amount of 0 to 15 wt-%, more preferred 0.5 to 10 wt-%, particularly preferred 1.5 to 7 wt-%, based on the dry layer weight.

Furthermore, the layer(s) can comprise surfactants (e.g. anionic, cationic, amphoteric or nonionic tensides or mixtures thereof). Suitable examples include fluorine-containing polymers, polymers with ethylene oxide and/or propylene oxide groups, sorbitol-tri-stearate and alkyl-di-(aminoethyl)-glycines. They are preferably present in an amount of 0 to 10 wt-%, based on the dry layer weight, especially preferred 0.2 to 5 wt-%.

The layer(s) can furthermore comprise print-out dyes such as crystal violet lactone or photochromic dyes (e.g. spiropyrans etc.). They are preferably present in an amount of 0 to 15 wt-%, based on the dry layer weight, especially preferred 0.5 to 5 wt-%.

Also, flow improvers can be present in the layer(s), such as poly(glycol)ether-modified siloxanes; they are preferably present in an amount of 0 to 1 wt-%, based on the dry layer weight.

The layer(s) can furthermore comprise antioxidants such as e.g. mercapto compounds (2-mercaptobenzimidazole, 2-mercaptobenzthiazole, 2-mercaptobenzoxazole and 3-mercapto-1,2,4-triazole), and triphenylphosphate. They are preferably used in an amount of 0 to 15 wt-%, based on the dry layer weight, especially preferred 0.5 to 5 wt-%.

### IMAGING

### IMAGEWISE EXPOSURE

If the absorber component used in the radiation-sensitive coating absorbs UV/VIS radiation, the precursors are imagewise exposed in a manner known to the person skilled in the art with UV/VIS radiation of a wavelength of about 250 to about 750 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 ± 10 nm), argon ion lasers emitting in the visible range (488 nm or 514 nm) and frequency-doubled fd:Nd:YAG lasers emitting at around 532 nm are of particular interest as a radiation source. The laser radiation can be digitally controlled via a computer, i.e. it can be turned on or off so that an imagewise exposure of the plates can be effected via stored digitized information in the computer; this way, so-called computer-to-plate (ctp) printing plates can be obtained.

If the absorber component absorbs IR radiation, i.e. noticeably absorbs radiation of a wavelength in the range of more than about 750 to about 1300 nm, and preferably shows an absorption maximum in this range in its absorption spectrum, imagewise exposure can be carried out with IR radiation sources. Suitable radiation sources are e.g. semi-conductor lasers or laser diodes which emit in the range of about 750 to about 1300 nm, for example Nd:YAG lasers (1,064 nm), laser diodes which emit between about 790 and about 990 nm, and Ti:sapphire lasers. The laser radiation can be digitally controlled via a computer, i.e. it can be turned on or off so that an imagewise exposure of the plates can be effected via stored digitized information in the computer; this way, so-called computer-to-plate (ctp) printing plates can be obtained. Any image-setters equipped with IR lasers that are known to the person skilled in the art can be used.

"Thermal plates" usually contain a photothermal conversion material (which absorbs radiation of a certain wavelength, and converts it to heat) and in most cases are sensitive to IR radiation. It is, however, also possible to directly apply heat in an imagewise manner (for instance by using a thermoprinting head).

The imagewise exposed precursor comprises exposed and unexposed areas of the coating. Depending on whether the precursor was positive working or negative working, the exposed areas correspond to non-image areas or image areas.

Any embodiment described with respect to the imagewise exposure can be combined with any suitable embodiment of the invention described above or below with respect to other aspects of the invention.

### DEVELOPING OF THE EXPOSED PRECURSOR

After exposure the precursor is treated with a developer in order to remove the coating in the non-image areas thereby revealing the substrate in said areas; if the precursor was a positive working one, the non-image areas correspond to the exposed areas while for negative working precursors the non-image areas correspond to the unexposed areas. According to one embodiment a preheat step can be carried out between exposure and treating with the developer.

If the precursor comprises an overcoat which protects the radiation sensitive coating, the overcoat can be removed by washing/rinsing with water before applying the developer.

Typically, the exposed precursor is contacted with the developer by rubbing or wiping the imageable layer with an applicator containing this liquid. Alternatively, the exposed precursor may be brushed with the developer or the developer may be applied to the precursor by spraying. The treatment with the developer can also be carried out by immersing the exposed precursor in a bath of the developer. According to one embodiment, the processing may be carried out in a commercially available processor, equipped with an immersion type developing bath, and a drying section. Additionally, a conductivity-measuring unit can be incorporated into the processor for controlling the developer activity of the developer.

The exposed precursor is typically treated with the developer at a temperature of 18°C to about 28°C, for a period of about 5 seconds to about 60 seconds.

After a certain number of exposed precursors have been processed, the developing activity (for instance measured by titration or conductivity measurement) of a developer bath falls below a predetermined level. Then fresh developer is added to the bath (also called "top-up" process). Usually about 20 mL to about 200 mL, typically about 30 to 120 mL, of fresh developer per 1 m² of precursor processed is necessary to keep both the volume of developer and its activity/conductivity value constant. The processed lithographic printing plate, comprises regions in which imageable layer has been removed revealing the underlying surface of the hydrophilic substrate, and complimentary regions in which the imageable layer has not been removed. The regions in which the imageable layer has not been removed are ink receptive.

Instead of adding fresh developer for keeping the activity of the developer bath constant a so-called replenisher can be added. The replenisher suitably differs from the fresh developer in that the concentration of the alkaline reagent is higher compared to the concentration of the alkaline reagent in the fresh developer used; the concentration of the other components might be the same or higher as in the fresh developer.

After having contacted the precursor with the developer any excess of said developer remaining on the precursor can be removed for instance by means of squeeze rollers

The developer used in the present invention is not particularly limited, but any developer which is capable of removing the non-image areas can be used.

Any embodiment described with respect to the developing can be combined with any suitable embodiment of the invention described above or below.

### Developer

The developer suitable for precursors according to the present invention is an aqueous solution having a pH value of >6, preferably a pH of from 7.5 to 13.5, more preferably a pH of from 10 to 13.5.

### Water

Tap water, deionized water or distilled water can be used. The amount of water is preferably in the range of 45 to 98 wt-%, based on the total weight of the developer, especially preferred 50 to 95 wt-% and particularly preferred 80 to 95 wt-%.

### Alkaline component

The developer used in the present invention optionally comprises an alkaline component.

The alkaline component can for instance be selected from alkali silicates, alkali hydroxides, Na₃PO₄, K₃PO₄, NR₄OH, wherein each R is independently selected from C₁-C₄ alkyl groups and C₁-C₄ hydroxyalkyl groups, amines and mixtures of 2 or more of the foregoing.

The amount of the alkaline component, or in case of mixtures the total amount of the alkaline components, is preferably selected such that the pH value of the developer is >6 to 14, preferably, the pH is in the range of 7.5 to 13.5, more preferably in the range of 10 to 13.5.

As used in the present invention, the term "alkali silicates" also encompasses metasilicates and water glasses. Sodium silicates and potassium silicates are preferred silicates. When alkali silicates are used, the amount of silicate is preferably at least 1 wt-% (calculated as SiO₂), based on the developer.

Of the alkali hydroxides, NaOH and KOH are especially preferred.

Usually the use of alkali metasilicates readily provides a pH value of more than 12 without further alkaline additives such as e.g. alkali hydroxide. When water glass is used, an alkali hydroxide is used in addition if a pH value of more than 12 is desired.

Preferred quaternary ammonium hydroxides NR₄OH include for example tetramethyl ammonium hydroxide, trimethylethanol ammonium hydroxide, methyltriethanol ammonium hydroxide and mixtures thereof; an especially preferred ammonium hydroxide is tetramethyl ammonium hydroxide.

Suitable amines are primary, secundary and tertiary amines. Examples are mono- and dialkanol amines like monoethanol amine and diethanol amine.

### Surfactant

A further optional component of the developer used in the present invention is the surfactant.

The surfactant is not specifically limited as long as it is compatible with the other components of the developer and soluble in aqueous alkaline solutions with a pH of >6. The surfactant can be a cationic, an anionic, an amphoteric or a nonionic one.

Examples of anionic surfactants include hydroxyalkanesulfonates, alkylsulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkyl-sulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkyletllers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylethers, salts of phosphoric esters of polyoxyethylenealkylphenylethers, partially saponified compounds of styrenemaleic anhydride copolymers, partially saponified compounds of olefin-maleic anhydride copolymers, naphthalenesulfonateformalin condensates, sodium dodecylphenoxybenzene disulfonates, the sodium salts of alkylated naphthalenesulfonate, disodium methylene-dinaphtalene-disulfonate, sodium dodecyl-benzenesulfonate, (di)sulfonated alkyldiphenyloxides, ammonium or potassium perfluoroalkylsulfonates and sodium dioctyl-sulfosuccinate.

Particularly preferred among these anionic surfactants are alkylnaphthalenesulfonates, disulfonated alkyldiphenyloxides, and alkylsulfonates.

Suitable examples of the nonionic surfactants include polyoxyethylene alkyl ethers, polyoxyethylene phenyl ethers, polyoxyethylene 2-naphthyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolaminealiphatic esters, and trialkylamine oxides. Particularly preferred among these nonionic surfactants are polyoxyethylene phenyl ethers and polyoxyethylene-2-naphthyl ethers.

Further, fluorine containing and silicone anionic and nonionic surfactants may be similarly used.

Amphoteric surfactants are for example N-alkylamino acid triethanol ammonium salts, cocamidopropyl betaines, cocamidoalkyl glycinates, sodium salt of a short chain alkylaminocarboxylate, N-2-hydroxyethyl-N-2-carboxyethyl fatty acid amidoethylamin sodium salts, and carboxcylic acid amidoetherpropionates; preferred are cocamidopropylbetaines.

Examples of cationic surfactants are tetraalkyl ammoniumchlorides like tetrabutyl ammoniumchloride and tetramethyl ammoniumchloride, and polypropoxylated quaternary ammonium chlorides.

Nonionic, anionic and amphoteric surfactants as well as mixtures thereof are preferred.

It is preferred that the developer used in the present invention comprises at least one member selected from surfactants and alkaline components.

Two or more of the above surfactants may be used in combination. The amount of the surfactant (or total amount of surfactants if more than one is used) is not specifically limited but is preferably from 0.01 to 20 wt-%, more preferably from 2 to 8 wt-% based on the total weight of the developer.

### Further optional components of the developer

Besides the essential components and the above-cited optional components the developer used in the present invention may contain further additives like organic solvents, biocides, complexing agents, buffer substances, dyes, antifoaming agents, odorants, anticorrosive agents and radical inhibitors.

### Antifoaming agents:

Suitable antifoaming agents include e.g. the commercially available Silicone Antifoam Emulsion SE57 (Wacker), TRITON^{®} CF32 (Rohm & Haas), AKYPO^{®} LF (ethercarboxylic acid Chem Y), Agitan 190 (Münzing Chemie), TEGO^{®} Foamese 825 (modified polysiloxane, TEGO Chemie Service GmbH, Germany). Silicone-based antifoaming agents are preferred. They are either dispersible or soluble in water. The amount of antifoaming agent in the developer is preferably 0 to 1 wt-%, based on the weight of the developer especially preferred 0.01 to 0.5 wt-%. One antifoaming agent or a mixture of two or more can be used.

### Buffers:

Suitable buffer substances include e.g. tris(hydroxymethyl)-aminomethane (TRIS), hydrogen phosphates, glycine, 3-(cyclohexylamino)-propane sulfonic acid (CAPS), hydrogen carbonates, borates including borax, 2-amino-2-methyl-1-propanol (AMP), 3-(cyclohexylamino)-2-hydroxy-1-propane-sulfonic acid (CAPSO), and 2-(N-cyclohexylamino)ethan-sulfonic acid (CHES).

### Biocides:

The biocides should be effective against bacteria, fungi and/or yeasts. Suitable biocides include e.g. N-methylol-chloroacetamide, benzoic acid, p-hydroxybenzoic acid esters, phenol or its derivatives, formalin, imidazol derivatives, isothiazolinone derivatives like 1,2-benzisothiazolin-3-on, benzotriazole derivatives, amidines, guanidine derivatives, quaternary ammonium salts, pyridine, quinoline derivatives, diazine, triazole derivatives, oxazole and oxazine derivatives and mixtures thereof. Their amount is not particularly restricted and preferably accounts for 0 to 10 wt-% in the developer, based on the total weight of the solution, especially preferred 0.1 to 1 wt-%. One biocide or a mixture of two or more can be used.

### Complexing agents:

Examples of suitable complexing agents include: Aminopolycarboxylic acid and salts thereof, such as ethylene diamine tetraacetic acid and potassium or sodium salts thereof, diethylene triamine pentaacetic acid and potassium or sodium salts thereof, triethylene tetraamino-hexaacetic acid and potassium or sodium salts thereof, hydroxyethyl ethylene diamine triacetic acid and potassium or sodium salts thereof, nitrilotriacetic acid and potassium or sodium salts thereof, 1,2-diaminocyclohexane-tetraacetic acid and potassium or sodium salts thereof and 1,3-diamino-2-propanol-tetraacetic acid and potassium or sodium salts thereof, and an organophosphonic acid, phosphonoalkane tricarboxylic acid or salts thereof, such as 2-phosphonobutane-1,2,4-tricarboxylic acid and potassium or sodium salts thereof, phosphonobutane-2,3,4-tricarboxylic acid and potassium or sodium salts thereof, phosphonoethane-2,2,2-tricarboxylic acid and potassium or sodium salts thereof, aminotris-(methylene-phosphonic acid) and potassium or sodium salts thereof and sodium gluconate. The complexing agents can be used individually or as a combination of two or more. Organic amine salts of the above-mentioned complexing agents can be used instead of the potassium or sodium salts thereof. The amount of complexing agent preferably accounts for 0 to 5 wt-% in the developer, based on the total weight of the solution, especially preferred 0.01 to 1 wt-%.

### Solvents:

The developer may also comprise an organic solvent or a mixture of organic solvents. The developer is a single phase. Consequently, the organic solvent must be miscible with water, or at least soluble in the developer to the extent it is added to the developer, so that phase separation does not occur. The following solvents and mixtures of these solvents are suitable for use in the developer: the reaction products of phenol with ethylene oxide and propylene oxide, such as ethylene glycol phenyl ether; benzyl alcohol; esters of ethylene glycol and of propylene glycol with acids having six or fewer carbon atoms, and ethers of ethylene glycol, diethylene glycol, and of propylene glycol with alkyl groups having six or fewer carbon atoms, such as 2-ethylethanol and 2-butoxyethanol. A single organic solvent or a mixture of organic solvents can be used. The organic solvent is typically present in the developer at a concentration of between about 0 wt-% to about 15 wt-%, based on the weight of the developer preferably between about 3 wt-% and about 5 wt-%, based on the weight of the developer.

### "Sludge inhibitors":

As described in detail in US 6,383,717 B1 and US 6,482,578 B2 sludge may be formed in a developer bath due to the build up of free-radical polymerizable material in the case of negative working precursors where imaging is based on free-radical polymerization in the coating of the precursor. Sludge formation may be prevented by the presence of at least one material selected from filter dyes and free-radical inhibitors in the developer. Filter dyes absorb ambient ultraviolet and visible radiation and reduce the amount absorbed by the radiation-sensitive initiator system present in the loaded developer. Free-radical inhibitors inhibit free-radical polymerization of the monomer in the loaded developer.

The absorption of the filter dye is matched to the absorption of the radiation-sensitive initiator system, furthermore the filter dye should be stable in the developer and should not undergo any chemical reaction or interaction with the components of the developer, or the radiation-sensitive layer.

The concentration of filter dye required to produce the stabilizing effect under daylight or similar conditions will depend on the number of factors; however, the concentration of the filter dye is preferably about 0 to 2 wt-%, based on the weight of the developer, preferably about 0.4 % to 2 wt-%, based on the weight of the developer.

The filter dye must be sufficiently soluble in the developer that enough filter dye can be dissolved in the developer to absorb radiation in the region about 350 nm to about 650 nm region of the spectrum. Dyes substituted with one or more sulfonic acid groups will typically have sufficient solubility in the developer. Preferred dyes include yellowish, yellow, orange and red dyes substituted with sulfonic acid groups. Especially preferred are sulfonated azo dyes. Suitable dyes include, for example, metanil yellow (C.I. 13065) and other similar water-soluble azo dyes, such as, for example, methyl orange (C.I. 13025), tropaeoline O (C.I. 14270), tropaeoline OO (C.I. 13080), tartrazine (C.I. 19140); Oxonol Yellow K (Riedel-de-Haen); dyes of the acid yellow type, such as C.I. 13900, C.I. 14170, C.I. 18835, C.I. 18965, C.I. 18890, C.I. 18900, C.I. 18950 (polar yellow), C.I. 22910, and C.I. 25135; and dyes of the acid red type, such as C.I. 14710, C.I. 14900, C.I. 17045, C.I. 18050, C.I. 18070, and C.I. 22890. Other suitable dyes will be readily apparent to those skilled in the art. A single filter dye or a mixture of filter dyes can be used.

Suitable free-radical inhibitors, also known as polymer stabilizers or free-radical traps, are well known in the art of monomer and polymer stabilization.

Any material that is capable of reacting with free-radicals to form products that do not initiate polymerization of the monomer, that has the necessary solubility and stability in the developer, and that does not adversely affect the properties of either the developer or the printing plate can potentially be used. They include, for example: compounds containing quinone or hydroquinone moieties, especially benzoquinone and substituted benzoquinones, and hydroquinone and substituted hydroquinones, such as hydroquinone monomethyl ether (4-methoxyphenol), t-butylhydroquinone (4-t-butylphenol, TBHQ), and t-butyl hydroxyanisol (BHA); recorcinol, pyrrogallol, phosphate esters; and hindered phenols and bisphenols, such as 2,6-di-t-butyl-4-methylphenol (BHT), and 2,6-di-t-butyl-4-methoxyphenol, 2,4,6-tri-t-butylphenol; stable free-radicals, such as di-t-butyl nitroxide and 2,2,6,6-tetramethyl-4-pyridone nitroxide; nitro substituted aromatics; amino phenols; phenothiazine; and secondary diaryl amines such as substituted diphenyl amines, N,N'-diphenyl-p-phenylenediamine, and N-phenylnaphthyl amine. Preferred radical inhibitors are quinones, hydroquinones, ethers of hydroquinones, and hindered phenols. More preferred are ethers of hydroquinones, especially ethers of hydroquinone and hindered phenols. Preferred compounds are hydroquinone monomethyl ether (4-methoxyphenol), 2,6-di-t-butyl-4-methylphenol, and 2,4,6-tri-t-butylphenol. A single free-radical inhibitor or a mixture of free-radical inhibitors can be used. The free-radical inhibitor or a mixture of free-radical inhibitors is typically present in the developer at a concentration of about 0 wt-% to about 3.0 wt-% based on the weight of the developer, preferably about 0.5 wt-% to about 1.5 wt-%, based on the weight of the developer.

### Anticorrosive agents:

Examples of anticorrosive agents are phosphonic acids and their salts like hydroxyethyl phosphonic acid and its salts, amino trismethylene phosphonic acid and its salts, and diethylentriaminpentamethylene phosphonic acid and its salts; phosphates like trisodium phosphate; borates like borax; as well as glycerol and glycols having the formula 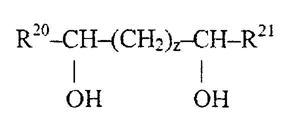 (wherein z is 0, 1 or 2 and R²⁰ and R²¹ are independently hydrogen or C₁-C₃ alkyl).

The anticorrosive agent or mixture of such agents is typically present in the developer at a concentration of about 0 to 10 wt-% based on the weight of the developer, preferably 0.1 to 5 wt-%, in case of glycerol or a glycol 5 to 10 wt-%.

### Further additives:

Odorants and dyes can also be present in the developer, if desired. The dyes are added in order to prevent confusion at the users when different processing chemicals like developer and replenisher are used parallel at the same user. Examples for classes of dyes that can be used are azo dyes, triarylmethan dyes or phthalocyanines. The concentration of the dyes in the developer is typically 0.0005 to 0.5 wt.-%.

Odorants are used in order to compensate unpleasant smell of other components in the developer. The typical concentration of odorants is within 0.001 to 1 wt.-%.

Any embodiment described with respect to the developing can be combined with any suitable embodiment of the invention described above.

### GUMMING TREATMENT

According to one embodiment imaged lithographic printing plates according to the present invention can be subjected to a gumming treatment after treatment with the developer and optional rinsing with water after developing. The gumming composition is applied using common coating processes such as e.g. manual application by a sponge, dip coating, roller coating, spray coating, coating with a doctor blade or squeezing rolls and coating with a slot coater. The composition used in this process has a temperature of preferably 20 to 90°C. The gumming can be carried out in the gumming section of a plate developing machine ("processor"). The viscosity of the gumming composition is not particularly restricted, however, it can influence the selection of the coating process (and vice versa).

The printing plate treated with the gumming composition is then dried, for example in the air or by means of a hot-air dryer or an infrared dryer. Drying is preferably carried out at a temperature of 20 to 120°C, especially preferred 20 to 80°C.

The gumming solution can be applied onto a printing plate immediately after imaging, i.e. before the printing plate is used for printing. This way, the surface of the printing plate is protected in case the plate is not used for printing immediately after imaging but stored for a certain amount of time.

The gumming solution can also be applied onto a printing plate that has already been used for printing. This is especially advisable if the printing machine is stopped for a prolonged period of time during printing, for example over the weekend.

The gumming thickness is usually at most 3 µm. Depending on the application method, the solids content of the gumming and the type of plate, the wet weight of the gumming is about 50 to 500 mg/m².

The gummed printing plates can be stored for several months before they are (again) mounted in the printing machine and used for printing. In practical applications, gummed printing plates are usually stored for about a week.

Any embodiment described with respect to the gumming treatment can be combined with any suitable embodiment of the invention described above or below with respect to other aspects of the invention.

### Aqueous Gumming Composition

A gumming composition to be used in a process according to the invention comprises water, and at least one member selected from surfactants and hydrophilic film-forming polymers. According to a preferred embodiment, the gumming composition comprises at least one hydrophilic film-forming polymer and at least one surfactant.

### Water

Tap water, deionized water or distilled water can be used. The amount of water is preferably in the range of 45 to 98 wt-%, based on the total weight of the gumming composition, especially preferred 50 to 95 wt-% and particularly preferred 80 to 95 wt-%.

### Film forming hydrophilic polymer

Examples of suitable polymers are gum arabic, pullulan, cellulose derivatives such as hydroxymethyl celluloses, carboxymethylcelluloses, carboxyethylcelluloses or methylcelluloses, starch derivatives like (cyclo)dextrins, poly(vinyl alcohol), poly(vinyl pyrrolidone), polyhydroxy compounds like polysaccharides, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid and acrylamidopropane sulfonic acid, polyhydroxy compounds and starch derivatives.

Polyhydroxy compounds and starch derivatives are especially preferred. The starch derivative should be water-soluble, preferably cold-water-soluble and is selected from starch hydrolysis products such as dextrins and cyclodextrins, starch esters, such as phosphate esters and carbamate esters, starch ethers, such as e.g. cationic starch ethers and hydroxypropyl ethers, carboxymethyl starch and acetylated starch; from the above derivatives dextrins (including dextrin comprising sodium tetraborate and available as borax dextrin from Emsland Stärke GmbH) are preferred.

The starch used as a starting product for the starch derivatives can be of various origins, it can e.g. be obtained from corn, potatoes, rye, wheat, rice, manioc, tapioca, chestnuts or acorns; corn starch and potato starch are preferred.

Suitable water-soluble polyhydroxy compounds can be represented by the following structure:

R¹(CHOH)ₙR²

in which n is 4 to 7; and
either (i) R¹ is hydrogen, aryl, or CH₂OH; and R² is hydrogen, an alkyl group having 1 to 4 carbon atoms, CH₂OR³ in which R³ is hydrogen or an alkyl group having 1 to 4 carbon atoms, CH₂N(R⁴R⁵) in which R⁴ and R⁵ are each independently hydrogen or an alkyl group having 1 to 4 carbon atoms, or CO₂H,
or (ii) R¹ and R² together form a carbon-carbon single bond.

In one group of polyhydroxy compounds, R¹ is hydrogen or CH₂OH and R² is hydrogen. In a preferred group of these polyhydroxy compounds, n is 5 or 6. This group includes the sugar alcohols, compounds of the structure H(CHOH)ₙH, which do not carry a free aldehyde or ketone group and do not show a reducing property. The sugar alcohols may be obtained from natural sources or prepared by hydrogenation of reducing sugars. Preferred sugar alcohols include mannitol, sorbitol, xylitol, ribitol, and arabitol. Other sugar alcohols include, for example, talitol, dulcitol, and allodulcitol.

In another group of polyhydroxy compounds, R¹ and R² together form a carbon-carbon single bond. Included are carbocyclic compounds of the structure: (CHOH)ₙ, in which n is 4 to 7. In a preferred group of these polyhydroxy compounds, n is 5 or 6, more preferably 6. There are nine possible stereoisomers of 1,2,3,4,5,6-hexahydroxycyclohexane, several of which are naturally occurring. A preferred polyhydroxy compound is meso-inosit (cis-1,2,3,5-trans-4,6-hexahydroxycyclohexane). meso-Inosit can be isolated from corn steep liquor.

In another group of polyhydroxy compounds, R¹ is hydrogen, aryl, or CH₂OH; and R² is an alkyl group having 1 to 4 carbon atoms, CH₂OR³ in which R³ is an alkyl group having 1 to 4 carbon atoms, CH₂N(R⁴R⁵) in which R⁴ and R⁵ are each independently H or an alkyl group having 1 to 4 carbon atoms, or CO₂H.

In another group of polyhydroxy compounds, R¹ is hydrogen or CH₂OH; and R² is CO₂H. More preferably, R¹ is H and n is 4 or 5. This group includes polyhydroxy compounds of the structure H(CHOH)ₙCO₂H, in which n is 4 or 5. Conceptually, these polyhydroxy compounds may be produced by oxidation of the corresponding hexose or pentose sugar, i.e., oxidation of the aldehyde group of a hexose sugar such as glucose, galactose, allose, mannose, etc., or oxidation of the aldehyde of a pentose sugar such as arabinose, ribose, xylose, etc.

Another hydrophilic polymer which can be used in the 2 in 1 developer comprises (m1) primary, secondary and/or tertiary amino groups, and
(m2) acid groups selected from -COOH, -SO₃H, -PO₂H₂ and PO₃H₂, (with COOH being preferred) and
(m3) optionally alkylene oxide units -(CHR¹-CH₂-O)ₚ-, wherein each R¹ independently represents H or -CH₃ and p is an integer from 1 to 50;
it is described in detail in EP 2 028 548 A1 which is incorporated herewith by reference.

The acidic functional groups present in this kind of hydrophilic polymer can all be in the form of a free acid, or all of said groups are in the form of a salt, or a part thereof is in the form of a free acid and the remaining part is in the form of a salt. When reference is made to the acidic functional group(s) in connection with the hydrophilic polymer this should include free acidic groups, salts and mixtures thereof unless defined otherwise.

According to one embodiment, the amino groups are bound to the polymer backbone either directly or via a spacer; suitable spacers are for instance C₁-C₄ alkylene groups. It is preferred within this embodiment that the amino groups are directly bound to a carbon atom of the polymer backbone; according to one embodiment, the hydrophilic polymer comprises structural units with amino groups represented by the following formula

According to another embodiment, the nitrogen atom of the amino groups is not part of a side chain but is part of the polymer backbone. Hydrophilic polymers of this embodiment can for instance comprise following structural units (A1) in the backbone: 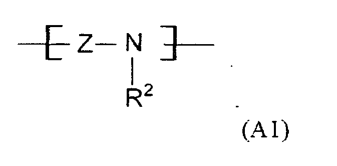 wherein Z is a straight chain or branched C₁-C₃ (preferably C₁-C₂) alkylene group and each R² independently represents H, C₁-C₄ alkyl, phenyl or -X-AG with each X being independently selected from divalent straight chain or branched saturated or unsaturated hydrocarbons (e.g. C₂-C₆ alkylene and arylene), alkylene oxide including polyalkylene oxide, and ethylene imine including polyethylene imine, (X is perferably a poly(alkylene)oxide or a poly(ethylene)imine) and each -AG independently representing an acid group as defined above. If the amino group in (A1) is a terminal amino group, a second R² as defined above is present; it is also possible that an additional third R² is bound resulting in a quaternized nitrogen atom.

According to one embodiment, the acid groups are bound to a carbon atom of the polymer backbone either directly or via a spacer; suitable spacers are for instance C₁-C₄ alkylene groups. For instance, the structural unit of the polymer comprising the acid group is represented by the following formula: 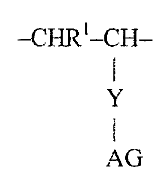 wherein R¹ is H or CH₃, Y is a single bond or a spacer (preferably alkyleneoxide, poly(alkylene)oxide, poly(ethylene)imine, ring opened lactones, ring opened lactames, ring opened anhydrides and carboxylic acids, and CₓH₂ₓ (x=1-6); especially preferred are poly(alkylene)oxide spacers, and AG is an acid group selected from -COOH, -SO₃H, -PO₂H₂ and -PO₃H₂, preferably -COOH.

According to another embodiment, the acid groups are bound to the nitrogen atoms of the amino groups via a spacer. It is especially preferred that in this case the nitrogen atom is part of the polymer backbone as shown in unit (A1) above and further exemplified in unit (A1'): 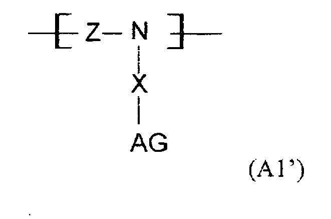 with Z, X and AG being as defined above.

The amount of the film forming polymer is not specifically limited; preferably it is from 1 to 30 wt-% based on the total weight of the gumming composition, more preferably from 3 to 20 wt-%.

### Optional components of the gumming composition

Besides the above-cited hydrophilic polymer the gumming composition used in the present invention may contain further additives like surfactants, organic solvents, biocides, complexing agents, buffer substances, dyes, antifoaming agents, odorants, anticorrosive agents, thickening agents, acidic and alkaline components. Suitable examples of these optional additives are mentioned above for the developer.

### Further additives:

Odorants and dyes can also be present, if desired. The dyes are added in order to prevent confusion when different processing chemicals like developer, replenisher and finisher are used at the same time. Examples for classes of dyes that can be used are azo dyes, triarylmethan dyes or phthalocyanines. The concentration of the dyes in the gumming composition is typically 0 to I wt.-%, preferably 0.0005 to 0.5 wt.-% based on the gumming composition. Odorants can be used in order to compensate unpleasant smell of other components in the gumming composition. The typical concentration of odorants is within 0.001 to 1 wt.-% based on the gumming composition.

Any embodiment described above for the gumming step can be combined with any other embodiment described in this invention.

### ALTERNATIVE PROCESSING POSSIBILITIES

As an alternative, instead of carrying out developing and gumming in two separate processing steps, it can be done in a single step (also referred to as "2 in 1 processing"). For doing so, a hydrophilic film forming polymer as described above for the gumming composition has to be added to an aqueous alkaline developer; according to one embodiment also (a) surfactant(s) is/are present in the developer.
The "2 in 1 processing" can be carried out by hand or in a commercial processor.

### BAKING TREATMENT

The imaged and developed element can be baked (or cured) in a postbake operation that can be carried out to increase run length of the resulting imaged element. Baking can be carried out in a suitable oven, for example at a temperature of less than 300°C and typically at less than 250°C for from about 2 to about 10 minutes. For example, the baking is done very quickly at a temperature of from about 160 to about 220°C for from about 2 to about 5 minutes.

Alternatively, the imaged and developed element (for example, printing plate) can be "baked" or cured by overall exposure to IR radiation at a wavelength of from about 800 to about 850 nm. This exposure creates conditions that enable very controllable baking effects with minimal distortion. For example, the imaged and developed element (for example, lithographic printing plate) can be passed through a commercial QuickBake 1250 oven (available from Eastman Kodak Company) at 4 feet (1.3 m) per minute at the 45% power setting of an infrared lamp to achieve a similar baking result from heating the element in an oven at 200°C for 2 minutes. Preferably the IR radiation is adjusted such that the temperature achieved is from about 140 to about 195°C and the dwell time at the desired temperature can for instance range from about 15 to 25 s. Details of this quick-bake procedure are disclosed in WO 2005/015318.

The present invention is described in more details in the following examples; however they are not intended to restrict the invention in any way.

### Examples

### Glossary of Chemicals used:

| | |
|---|---|
| Ethyl violet | contrast dye, C.I. 42600 (CAS 2390-59-2, λmax = 596 nm), represented by the following formular p-(CH₃CH₂)₂N(C₆H₄)₃C⁺ Cl⁻. |
| IR Dye A | (Trump dye), represented by the following formula, can be obtained from Eastman Kodak Company (Rochester, NY) 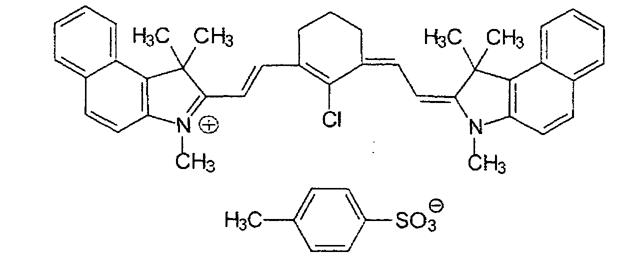 |
| IR Dye B | represented by the following formula, can be obtained from FEW, Germany 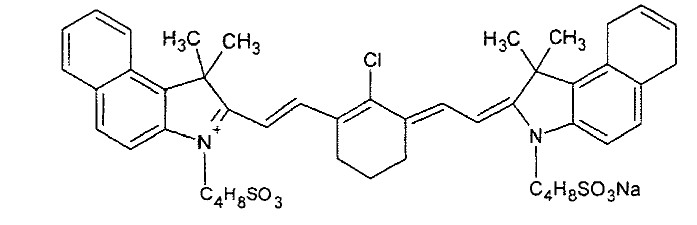 |
| Copolymer A | copolymer having recurring units derived from N-phenylmaleimide, methacrylamide, and methacrylic acid (45:35:20 mol %) |
| Copolymer B | copolymer having recurring units derived from methacylamide, N-tetrazol, N-phenylmaleimide, and N-(2-methacryloyloxyethyl) ethylene urea (31:40:29 mol %) |
| Copolymer C | copolymer having recurring units derived from methacylamide, N-tetrazol, N-phenylmaleimide, methacrylic acid, methacryl-amide and and acrylonitrile (13:18:4:10:55 mol %) |
| DEK | diethyl ketone |
| PM | propylene glycol methyl ether, obtained from Dow Chemical, USA |
| PMA | 1-methoxy-2-propyl acetate |
| BLO | γ-butyrolactone |
| Byk® 307 | polyethoxylated dimethylpolysiloxane copolymers that is available from Byk Chemise (Wallingford, CT) |
| Substrate A | 0.3 mn gauge aluminum sheet that had been electrograined, anodized, and subjected to treatment with poly(vinyl phosphonic acid) |
| Vestagon HA 320 | beta-hydroxy alkylamide crosslinker, obtainable from Evonic Industries |
| D11 | triarylmethan dye (CAS 433334-19-1), represented by the following formular 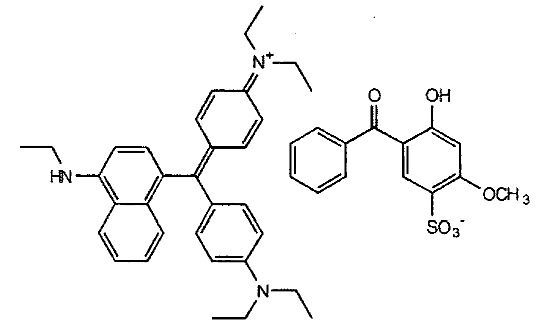 |
| DMABA | dimethylaminobenzoic acid |
| P3000 | pyrogallol-acetone novolak derivatized with naphthoquinone-diazide |
| Powderlink 1174 | 1,3,4,6-tetrakis(methoxymethyl)glycoluril crosslinking agent, available from Cytec Industries, USA |
| CYMEL303 | hexamethoxymethylmelamine crosslinking agent, available from Cytec Industries, USA |
| PD140 | m/p-cresol novolak |
| RX04 | styrene-maleic anhydride copolymer |
| SPN562 | 44% solution of m-cresol novolak, obtainable from AZ Chemicals, Germany |
| Developer 980 | low pH developer from Kodak used mainly for negative conventional and thermal photopolymer plates, comprising alkanolamines, surfactants, phenoxyalkanols and complexing agents |

### Synthesis of Resin A

A 500 ml 3-neck round-bottomed flask fitted with reflux was set-up in a thermostatic water bath. To the flask containing 236,21g SPN562 was added 180g Dowanol® PM. The solution was heated to 85°C and 26,7g KOH ground to fine powder was added and stirred for 10 mins. This was followed by addition 12,76g chloroacetic acid and the reaction mixture was allowed to react at 85°C for 5 hours. After 5 hours, the reaction mixture was neutralized with 29,0g HCl (33%). The solution was poured into water in a 1 litre beaker and ground with a mixer giving a fine suspension (pH approx. 4). The polymer was filtered off, washed on the filter with water to pH 6-7 and then dried in an oven at 40°C over night.

Lithographic printing plates were prepared as follows:

### Plate with bottom layer A

A plate with bottom layer was obtained by dissolving 1,96g Copolymer A, 0,15 g Vestagon HA320, 0,38g IR Dye A, 0,038 g dye D11 and 0,038g Byk 307 in 37,5 g of a solvent mixture (MEK /PM/BLO / H₂O with 45% / 35% / 1.0%/ 10%), coating it onto Substrate A and drying at 135°C for 45 seconds to provide a dry coating weight of 1.35 g/m².

### Plate with bottom layer B

A plate with bottom layer was obtained by dissolving 2,63g Copolymer B, 0,36 g Vestagon HA320, 0,30g IR Dye B, 0,038 g dye D11 and 0,038g Byk 307 in 37,5 g of a solvent mixture (MEK /PM/BLO / H₂O with 45% / 35% / 10%/ 10%), coating it onto Substrate A and drying at 135°C for 45 seconds to provide a dry coating weight of 1.36 g/m².

### Plate with bottom layer C

A plate with bottom layer was obtained by dissolving 2,48g Copolymer C, 0,15 g Vestagon HA320, 0,09g DMABA, 0,15 g IR Dye B, 0,03 g IR Dye B, 0,04g dye D11 and 0,038g Byk 307 in 37,5 g of a solvent mixture (MEK /PM/BLO / H₂O with 45% / 35% / 10%/ 10%) and coating it onto Substrate A and drying at 135°C for 45 seconds to provide a dry coating weight of 1.45 g/m².

### Plate with comparative bottom layer A

A plate with bottom layer was obtained by dissolving 2,11g Copolymer A, 0,38g IR Dye A, 0,038 g dye D11 and 0,038g Byk 307 in 37,5 g of a solvent mixture (MEK /PM/BLO / H₂O with 45% / 35% / 10%/ 10%), coating it onto Substrate A and drying at 135°C for 45 seconds to provide a dry coating weight of 1.38 g/m².

### Plate with comparative bottom layer B

A plate with bottom layer was obtained by dissolving 2,99g Copolymer B, 0,30g IR Dye B, 0,038 g dye D11 and 0,038g Byk 307 in 37,5 g of a solvent mixture (MEK /PM/BLO / H₂O with 45% / 35% / 10%/ 10%), coating it onto Substrate A and drying at 135°C for 45 seconds to provide a dry coating weight of 1.38 g/m².

### Plate with comparative bottom layer C

A plate with bottom layer was obtained by dissolving 2,63g Copolymer C, 0,09g DMABA, 0,15 g IR Dye B, 0,03 g IR Dye B, 0,04g dye D11 and 0,038g Byk 307 in 37,5 g of a solvent mixture (MEK /PM/BLO / H₂O with 45% / 35% / 10%/ 10%), coating it onto Substrate A and drying at 135°C for 45 seconds to provide a dry coating weight of 1.42 g/m².

### Plate with comparative bottom layer D

The same formulation as for bottom layer C was used except that 0.15 g CYMEL 303 were used instead of 0.15g Vestagon HA320.

### Plate with comparative bottom layer E

The same formulation as for bottom layer C was used except that 0.15 g Powderlink 1174 were used instead of 0.15g Vestagon HA320.

### Plate 1 and Comparative Plate 1 (2-layer plates)

A formulation for a top layer A was prepared by dissolving 4,8 g PD140A, 2,1g P3000, 0,03g Ethyl Violet and 0,04g Byk 307 in 100 ml DEK/PMA 92/8 w%. Said formulation was coated over bottom layer A and comparative bottom layer A, respectively to give Plate 1 and Comparative Plate 1 respectively, each having a top layer with a dry coating weight of 0.65 g/m² after having been dried at 130°C for 45 s.

### Plate 2 and Comparative Plate 2 (2-layer plates)

A formulation for a top layer B was prepared by dissolving 2,38 g RX04, 0,03g Ethyl Violet and 0,04g Byk 307 in 100 ml DEK/PMA 92/8 w%. Said formulation was coated over bottom layer B and comparative bottom layer B, respectively to give Plate 2 and Comparative Plate 2 respectively, each having a top layer with a dry coating weight of 0.55 g/m² after having been dried at 130°C for 45 s.

### Plate 3 and Comparative Plates 3-5 (2-layer plates)

A formulation for a top layer C was prepared by dissolving 3,8 g Resin A, 0,96 g RX04, 0,03g Ethyl Violet and 0,04g Byk 307 in 76 g DEK/PMA 92/8 w%. Said formulation was coated over bottom layer C (Plate 3), comparative bottom layer C (Comparative Plate 3), comparative bottom layer D (comparative Plate 4) and comparative bottom layer E (Comparative Plate 5), respectively, each having a top layer with a dry coating weight of 0.58 glm² after having been dried at 130°C for 45 s.

### Baking

To test the baking property of the bottom layers, strips of the plates coated with only the bottom layer or comparative bottom layer were heated in an oven at 200°C, 220°C , 240°C for 2 mins and mins . To check the completion of baking, the deletion Fluid 243 (Kodak Product) was applied at various lengths of time up to 8 mins and wiped off using a moist Polytamp. The attack of the coating is then evaluated.

The removal of the coating with the deletion fluid was assessed visually and evaluated with a scale of 0-10 with 0 denoting complete removal of coating and 10 denoting full bakeability. The results are summarized in Table 1.

**Table 1**

| | 2 mins/200°C | 5 mins/200°C | 2 mins/220°C | 5 mins/220°C |
|---|---|---|---|---|
| Bottom Layer A | 2 | 7 | 10 | 10 |
| Comparative Bottom Layer A | 0 | 0 | 0 | 0 |
| Bottom Layer B | 5 | 9 | 10 | 10 |
| Comparative Bottom Layer B | 2 | 3 | 5 | 5 |
| Bottom Layer C | 9 | 10 | 10 | 10 |
| Comparative Bottom Layer C | 1 | 2 | 1 | 3 |
| Comparative Bottom Layer D | 9 | 10 | 10 | 10 |

It is apparent from Table 1 that Bottom layer C shows as good bakeability as Comparative Bottom layer D.

Plates 1 to 3 and Comparative Plates 1 to 5 were imaged with test patterns at 150 rpm and 360 rpm in steps of 20 rpm using a Creo Quantum 800 imagesetter (58 to 139 mJ/cm²). The plates were developed with 980 developer in a Mercury processor at 2000 mm/min. The clear point and 8x8 pixel dot size was noted and the 1x1 pixles evaluated visually. No significant shifts in clear points and resolution of the plates were seen through the addition of the crosslinker. The tonal values of 1% and 2% dots were inspected with the microscope. All the plates showed good resolution of 1% at 200 lpi except that of comparative example 5 which lost all its image. The results are summarized in Table 2.

**Table 2**

| | Clear Point* | Clear Point after simulated aging (40°C, 80% rel. humidity) | 1x1 pixels | 8x8 pixels (50% dot value) |
|---|---|---|---|---|
| Plate 1 | 87 mJ/cm² | 83 mJ/cm² | good | 48.5 |
| Comparative Plate 1 | 87 mJ/cm² | 83 mJ/cm² | good | 48.2 |
| Plate 2 | 83 mJ/cm² | 83 mJ/cm² | good | 49.2 |
| Comparative Plate 2 | 87 mJ/cm² | 87 mJ/cm² | good | 48.9 |
| Plate 3 | 67 mJ/cm² | 67 mJ/cm² | good | 50.2 |
| Comparative Plate 3 | 72 mJ/cm² | 72 mJ/cm² | good | 50.5 |
| Comparative Plate 4 | 67 mJ/cm² | >139 mJ/cm² | good | 50.4 |

| | | | | |
|---|---|---|---|---|
| minimum power required to get a clean background | | | | |

Although the bottom layer of Comparative Plate 4 showed the same bakeability properties as the bottom layer of Plate 3, Comparative Plate 4 had severe aging problems while no such problems occurred with Plate 3.

For Comparative Plate no image was obtained after processing the plate.

### Aging Simulation

The plates were subjected to simulated aging by placing them in an oven set at 40°C and 80% relative humidity for 3 days. After this time the plates were taken out and allowed to equilibrate under room conditions for 1 day. The clear points of the plates were measured as described above. No significant clear point shifts were seen after aging on the all the plates except that of comparative plate 4. The plate was not clean at the exposure range of 58 to 139 mJ/cm².

The above experimental data demonstrate that the use of β-hydroxyalkylamine crosslinkers can be useful for improving the bakeability of printing plates. Due the effectiveness of the small amounts necessary for improving bakeabiliy, the original prepress properties like resolution and clear point remain unchanged.

Aging simulation tests showed no disadvantage with respect to clear point and resolution compared to the Cymel 303 which is another kind of crosslinker; however, the clear point after aging is very bad for Cymel 303 while the plates according to the invention showed no aging problems (i.e. there was no clear point shifting).

## Claims

1. Lithographic printing plate precursor comprising
a substrate, and
a positive working imageable coating which comprises
(i) a polymer containing acidic groups selected from -COOH, -SO₃H, -SO₂NHR, -PO₃H₂, -PO₂H₂ and 1H-tetrazol groups and
(ii) at least one β-hydroxy alkylamide crosslinker.

2. Precursor according to claim 1, wherein the coating is a single layer or multilayer coating which is sensitive to UV or visible radiation of a wavelength of 250 to 750 nm.

3. Precursor according to claim 1, wherein the coating is a single layer or multilayer coating which is sensitive to IR radiation of a wavelength of >750 nm to 1300 nm.

4. Precursor according to any one of claims 1 to 3, wherein the polymer contains -COOH groups and/or 1H-tetrazol groups.

5. Precursor according to any one of claims 1 to 3, wherein the at least one β-hydroxyalkylamide crosslinker is represented by the following formula. 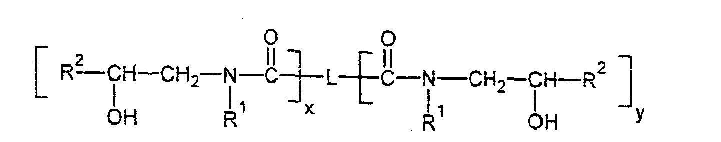 wherein each R¹ is independently selected from H, C₁-C₅alkyl and 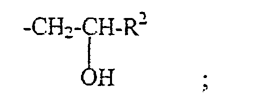 each R² is independently selected from H and C₁-C₅ alkyl,
L is a monovalent or polyvalent organic radical selected from saturated, unsaturated and aromatic hydrocarbons containing 1 to 20 carbon atoms and optionally further substituents,
x is 1 or 2
y is 0, 1 or 2
with x+y being at least 2 if R¹ is different from

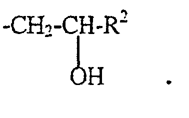

6. Precursor according to any one of claims 1 to 5, wherein the imageable coating consists of 2 layers.

7. Precursor according to claim 6, wherein the polymer (i) and crosslinker (ii) are both present in the bottom layer.

8. Method for preparing an imaged lithographic printing plate, comprising
(a) imagewise exposure of a precursor as defined in any one of claims 1 to 7 to radiation for which the coating is sensitive
(b) removing the non-image areas of the coating with a developer solution
(c) baking treatment of the imaged plate

9. Method according to claim 8, wherein the baking treatment is carried out in an oven at a temperature of less than 300°C for 2 to 10 minutes or by overall exposure to IR radiation for 15 to 25 seconds.

10. Lithographic printing plate comprising a substrate and an imaged coating the plate being obtainable by the method of any one of claims 8 to 9.

11. Use of a β-hydroxy alkylamide crosslinker for improving bakeability of positive working lithographic printing plates.

12. Use of a β-hydroxy alkylamide crosslinker for improving the aging properties of positive working lithographic printing plates.

## Patentansprüche

1. Offsetdruckplattenvorläufer mit
einem Substrat und
einer positiv arbeitenden, bebilderbaren Beschichtung, die Folgendes umfasst:
(i) ein Polymer mit Säuregruppen, ausgewählt aus -COOH, -SO₃H, -SO₂NHR, - PO₃H₂, -PO₂H₂ und 1H-Tetrazolgruppen, und
(ii) mindestens ein β-Hydroxyalkylamid-Vernetzungsmittel.

2. Vorläufer nach Anspruch 1, worin die Beschichtung aus einer einzelnen Schicht oder aus mehreren Schichten besteht, die gegenüber UV-Strahlung oder sichtbarer Strahlung mit einer Wellenlänge von 250 bis 750 nm empfindlich ist bzw. sind.

3. Vorläufer nach Anspruch 1, worin die Beschichtung aus einer einzelnen Schicht oder aus mehreren Schichten besteht, die gegenüber IR-Strahlung mit einer Wellenlänge von >750 nm bis 1300 nm empfindlich ist bzw. sind.

4. Vorläufer nach einem der Ansprüche 1 bis 3, worin das Polymer -COOH-Gruppen und/oder 1H-Tetrazolgruppen umfasst.

5. Vorläufer nach einem der Ansprüche 1 bis 3, worin das mindestens eine β-Hydroxyalkylamid-Vernetzungsmittel dargestellt ist durch folgende Formel: 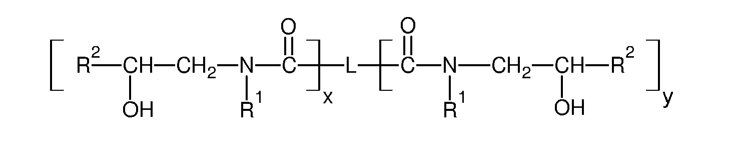 worin jeweils R¹ unabhängig ausgewählt ist aus H, C₁-C₅-Alkyl und 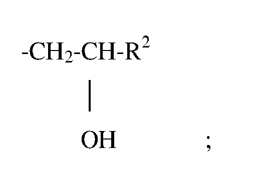 jeweils R² unabhängig ausgewählt ist aus H und C₁-C₅ Alkyl,
L ein einwertiges oder mehrwertiges organisches Radikal ist, ausgewählt aus gesättigten, ungesättigten und aromatischen Kohlenwasserstoffen mit 1 bis 20 Kohlenstoffatomen und wahlweise weiteren Substituenten,
x für 1 oder 2 steht
y für 0, 1 oder 2 steht
wobei x+y mindestens 2 beträgt, wenn R¹ anders ist als

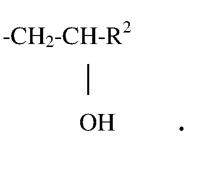

6. Vorläufer nach einem der Ansprüche 1 bis 5, worin die bebilderbare Beschichtung zwei Schichten umfasst.

7. Vorläufer nach einem der Ansprüche 1 bis 6, worin das Polymer (i) und das Vernetzungsmittel (ii) beide in der unteren Schicht vorhanden sind.

8. Verfahren zur Herstellung einer bebilderten Offsetdruckplatte mit folgenden Schritten:
(a) bildweises Belichten eines Druckvorläufers nach einem der Ansprüche 1 bis 7 mit einer Strahlung, gegenüber der die Beschichtung empfindlich ist
(b) Entfernen der nicht bebilderten Bereiche der Beschichtung mithilfe einer Entwicklerlösung
(c) Einbrennbehandeln der bebilderten Druckplatte

9. Verfahren nach Anspruch 8, worin die Einbrennbehandlung in einem Ofen bei einer Temperatur von weniger als 300 °C für 2 bis 10 Minuten oder durch eine Gesamtbeaufschlagung mit IR-Strahlung für 15 bis 25 Sekunden durchgeführt wird.

10. Offsetdruckplatte mit einem Substrat und einer bebilderten Beschichtung, herstellbar nach dem Verfahren gemäß einem der Ansprüche 8 bis 9.

11. Verwendung eines β-Hydroxyalkylamid-Vernetzungsmittels zur Verbesserung der Einbrennbarkeit positiv arbeitender Offsetdruckplatten.

12. Verwendung eines β-Hydroxyalkylamid-Vernetzungsmittels zur Verbesserung der Alterungseigenschaften positiv arbeitender Offsetdruckplatten.

## Revendications

1. Précurseur de plaque d'impression lithographique comprenant
un substrat, et
un revêtement pouvant être formé en image par impression positive, lequel comprend
(i) un polymère contenant des groupements acides sélectionnés à partir de -COOH, -SO₃H, -SO₂NHR, -PO₃H₂, -PO₂H₂ et des groupements 1H-tétrazole et
(ii) au moins un agent de réticulation alkylamide β-hydroxy.

2. Précurseur selon la revendication 1, dans lequel le revêtement est un revêtement à une seule couche ou à multiples couches qui est sensible à un rayonnement UV ou à un rayonnement visible d'une longueur d'onde de 250 à 750 nm.

3. Précurseur selon la revendication 1, dans lequel le revêtement est un revêtement à une seule couche ou à multiples couches qui est sensible à un rayonnement infrarouge d'une longueur d'onde de > 750 nm à 1300 nm.

4. Précurseur selon l'une quelconque des revendications 1 à 3, dans lequel le polymère contient des groupements -COOH et/ou des groupements 1H-tétrazole.

5. Précurseur selon l'une quelconque des revendications 1 à 3, dans lequel le au moins un agent de réticulation β-hydroxyalkylamide est représenté par la formule suivante 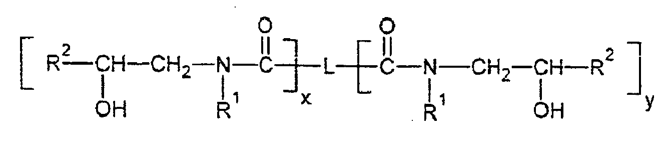 où chaque R¹ est indépendamment sélectionné à partir de H, un alkyle en C₁ à C₅ et 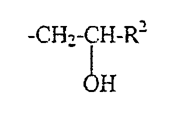 chaque R² est indépendamment sélectionné à partir de H et d'un alkyle en C₁ à C₅, L est un radical organique monovalent ou polyvalent sélectionné à partir d'hydrocarbures saturés, insaturés et aromatiques contenant de 1 à 20 atomes de carbone et éventuellement de substituants supplémentaires,
x vaut 1 ou 2
y vaut 0, 1 ou 2
x + y valant au moins 2 si R¹ est différent de

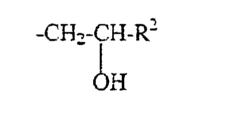

6. Précurseur selon l'une quelconque des revendications 1 à 5, dans lequel le revêtement pouvant être formé en image est constitué de 2 couches.

7. Précurseur selon la revendication 6, dans lequel le polymère (i) et l'agent de réticulation (ii) sont tous deux présents dans la couche inférieure.

8. Procédé de préparation d'une plaque d'impression lithographique formée en image, comprenant
(a) une exposition conforme à une image d'un précurseur défini selon l'une quelconque des revendications 1 à 7 à un rayonnement auquel le revêtement est sensible
(b) le retrait des zones sans image du revêtement avec une solution de révélateur
(c) le traitement de cuisson de la plaque formée en image.

9. Procédé selon la revendication 8, dans lequel le traitement de cuisson est effectué dans un four à une température inférieure à 300°C pendant 2 à 10 minutes ou par une exposition globale à un rayonnement infrarouge pendant 15 à 25 secondes.

10. Plaque d'impression lithographique comprenant un substrat et un revêtement formé en image, la plaque pouvant être obtenue par le procédé selon l'une quelconque des revendications 8 à 9.

11. Utilisation d'un agent de réticulation β-hydroxyalkylamide destinée à une amélioration de l'aptitude de cuisson de plaques d'impression lithographique par impression positive.

12. Utilisation d'un agent de réticulation β-hydroxyalkylamide destinée à une amélioration des propriétés de vieillissement de plaques d'impression lithographique par impression positive.
